# EUROPEAN PATENT SPECIFICATION

(11) **EP 1 590 994 B1**
(45) Date of publication and mention of the grant of the patent: **18.05.2016**
(21) Application number: 04708463.7
(22) Date of filing: 05.02.2004
(51) Int. Cl.: H05K 1/00, H01L 25/075

(54) **METAL BASE WIRING BOARD FOR RETAINING LIGHT EMITTING ELEMENTS, LIGHT EMITTING SOURCE, LIGHTING APPARATUS, AND DISPLAY APPARATUS**
LEITERPLATTE MIT EINER METALLBASIS FÜR LICHTEMITTIERENDE ELEMENTE, LICHTQUELLE, BELEUCHTUNGSVORRICHTUNG UND ANZEIGEVORRICHTUNG
PANNEAU DE CABLAGE À BASE MÉTALLIQUE POUR LA RETENUE D'ÉLÉMENTS ÉLECTROLUMINESCENTS, SOURCE ÉLECTROLUMINESCENTE, APPAREIL D'ÉCLAIRAGE, ET APPAREIL D'AFFICHAGE

(30) Priority: 07.02.2003 JP 2003031698; 07.02.2003 JP 2003031699
(43) Date of publication of application: 02.11.2005
(73) Proprietor: Panasonic Intellectual Property Management Co., Ltd., Osaka 540-6207 (JP)
(72) Inventor: MATSUI, Nobuyuki, Chuo-ku, Osaka-shi, Osaka, 540-6319 (JP); SETOMOTO, Tatsumi, Chuo-ku, Osaka-shi, Osaka, 540-6319 (JP); TAMURA, Tetsushi, Chuo-ku, Osaka-shi, Osaka, 540-6319 (JP); SHIMIZU, Masanori, Kyotanabe-shi, Kyoto 610-0331 (JP); YAMASHITA, Yoshihisa, Kyoto-shi, Kyoto 604-8804 (JP)
(74) Representative: Eisenführ Speiser
(86) International application number: PCT/JP2004/001195
(87) International publication number: WO 2004/071141

(56) References cited:
- EP-A- 1 253 650
- WO-A-2004/049462
- US-A- 4 935 665
- PATENT ABSTRACTS OF JAPAN vol. 2003, no. 12, 5 December 2003 (2003-12-05) & JP 2004 241509 A (MATSUSHITA ELECTRIC IND CO LTD), 26 August 2004 (2004-08-26)
- PATENT ABSTRACTS OF JAPAN vol. 1996, no. 05, 31 May 1996 (1996-05-31) -& JP 08 008463 A (SHARP CORP), 12 January 1996 (1996-01-12)
- PATENT ABSTRACTS OF JAPAN vol. 2000, no. 03, 30 March 2000 (2000-03-30) -& JP 11 345999 A (MATSUSHITA ELECTRON CORP), 14 December 1999 (1999-12-14)
- GALLAGHER C ET AL: "Materials selection issues for high operating temperature (HOT) electronic packaging" HIGH-TEMPERATURE ELECTRONIC MATERIALS, DEVICES AND SENSORS CONFERENCE, 1998 SAN DIEGO, CA, USA 22-27 FEB. 1998, NEW YORK, NY, USA,IEEE, US, 22 February 1998 (1998-02-22), pages 180-189, XP010313535 ISBN: 0-7803-4437-5

## Description

### Technical Field

The present invention relates to a metal base wiring board for retaining light emitting elements, a light emitting source composed of the metal base wiring board and the light emitting elements mounted therein, and a lighting apparatus and a display apparatus using the light emitting source, specifically to a technology for improving heat dissipation during light emission by the light emitting elements.

### Background Art

An LED light source using LED (Light Emitting Diode) is required to retain a lot of LEDs on a surface thereof (that is, on a surface of an insulation layer) since each LED outputs a small amount of optical power. The LEDs generate heat as they emit light, and increase the temperature thereof. The increase in temperature leads to reduction of light emitting efficiency or short life of LEDs.

One of technologies proposed to improve the heat dissipation of such light emitting sources is a metal base wiring board in which a metal base is attached to a rear surface of an insulation substrate for the purpose of releasing the generated heat (for example, see Japanese Laid-Open Patent Application No.2002-184209). In this metal base wiring board, the generated heat is transmitted from the insulation substrate, on which LEDs are mounted, to the metal base to be released from it.

In such light emitting sources, if a small number of LEDs are mounted on the insulation substrate, a small amount of heat is generated. In that case, there is no problem in releasing the generated heat. However, when a larger number of LEDs are mounted to increase the optical power output per unit area, the spacing between adjacent LEDs becomes narrower, causing the temperature to rise as they emit light. That is to say, conventional metal base wiring boards provide insufficient heat dissipation for a high optical power output.

JP8008463A relates to a LED dot matrix unit having a first metallic layer blocking the aperture parts of through holes provided on the rear surface of an insulating substrate having the through holes arranged in a matrix form. LED Chips are respectively fixed to the first metallic layer in the through holes of the insulating substrate using a conductive paste. Second metallic layers are provided on the front side of the insulating substrate excluding the aperture parts of the through holes. The second metallic layers are connected to LED chips by metallic fine wires.

JP11345999A relates to a photoelectric conversion device and a first printed board has a through hole whose aperture on the surface is larger than that on the back, and the inner surface of the through hole is plated with metal. An electrode pattern for mounting a photoelectric conversion element is formed on the surface of a second printed board. The first printed board is stuck on the second printed board in such a manner that the central part of the through hole coincides with the central part of the electrode pattern. The photoelectric conversion element is mounted on the electrode pattern.

US 4,935,665A describes light emitting diode lamp which comprises an insulated metallic board having a plurality of hollows thereon each of which has a light emitting diode mounted on the bottom thereof and a light-reflecting surface on the side wall thereof. A lens plate collects direct light from the light emitting diode and light reflected by the reflecting surfaces of each of the hollows.

### Disclosure of the Invention

The object of the present invention is therefore to provide a metal base wiring board, a light emitting source, a lighting apparatus and a display apparatus for providing improved heat dissipation.
(1) The above object is fulfilled by a metal base wiring board for retaining light emitting elements in accordance with claim 1. The metal base wiring board comprises: an insulation substrate having a plurality of recesses whose bottom faces are planned mounting position of the light emitting elements, and including a wiring pattern formed therein to interconnect the light emitting elements mounted in the recesses; and a metal base attached to a rear surface of the insulation substrate.
   With the above-described construction in which the light emitting elements are mounted on the bottom faces of the recesses, the distance between the light emitting elements and the metal base is reduced, thus improving the heat dissipation compared with the case where the light emitting elements are mounted on the front surface of the insulation substrate.
(2) In the metal base wiring board of claim 1, the insulation substrate has a multi-layer structure composed of a plurality of insulation layers, and the recesses pass through insulation layers starting with a top layer of the plurality of insulation layers, leaving intact at least a bottom layer that is attached to the metal base.
   With the above-described construction, the distance between the light emitting elements and the metal base is reduced even though the insulation substrate has a plurality of insulation layers, thus improving the heat dissipation compared with the case where the light emitting elements are mounted on the front surface of the insulation substrate. In particular, a resin based material is used for the insulation layers, superior heat dissipation is obtained since the heat dissipation of a light emitting source heavily depends on the thickness or the number of insulation layers.
(3) In the metal base wiring board of (2), the bottom faces of the recesses may be part of a front surface of any of the plurality of insulation layers.
   With the above-described construction, the recesses can be formed easily by opening the through holes to pass through insulation layers that are upper than the insulation layer whose front surface is partially the bottom faces of the recesses.
(4) In the metal base wiring board of claim 1, a first wiring pattern is formed in the front surface of the insulation layer that is partially the bottom faces of the recesses, and part of the wiring pattern is exposed in the recesses.
   With the above-described construction, a wiring pattern can be formed easily to be embedded in the bottom faces of the recesses by first forming the wiring pattern to be embedded in the front surface of a given insulation layer, and then stacking insulation layers on the insulation layer. It is also easy to expose the wiring pattern in the recesses by varying the form of the wiring pattern for each layer.
(5) In the metal base wiring board of claim 1, the bottom faces of the recesses may be part of a front surface of any of the plurality of insulation layers, and the wiring pattern includes: the first wiring pattern that has a plurality of rows of light emitting element connecting unit for connecting the light emitting elements in series, and is formed in the front surface of the insulation layer that is partially the bottom faces of the recesses; and a second wiring pattern that connects the plurality of rows of light emitting element connecting unit in series, and is formed in a front surface of an insulation layer that exists on a front side of the insulation layer that is partially the bottom faces of the recesses.
(6) In the metal base wiring board of (2), the bottom faces of the recesses may be part of a front surface of any of the plurality of insulation layers, and the wiring pattern is formed in a front surface of an insulation layer that exists on a front side of the insulation layer that is partially the bottom faces of the recesses.
   With the above-described construction, it is possible to divide a wiring pattern among a plurality of insulation layers. This enables the light emitting elements to be mounted the insulation substrate in high density.
(7) In the metal base wiring board of (1), the recesses may pass through the insulation substrate and reach the metal base. However, this is not claimed.
   With the above-described construction, it is possible to mount the light emitting elements on the metal base. This enables the heat generated as the light emitting elements emit light is transmitted to the metal base directly, thus improving the heat dissipation of the wiring board.
(8) In the metal base wiring board of (7), the wiring pattern may include: a third wiring pattern that has a plurality of rows of light emitting element connecting unit for connecting the light emitting elements in series; and a fourth wiring pattern for connecting the plurality of rows of light emitting element connecting unit in series.
(9) In the metal base wiring board of (8), the insulation substrate may have a multi-layer structure composed of two or more insulation layers, and the third wiring pattern and the fourth wiring pattern are formed in different insulation layers in the multi-layer structure.
   With the above-described construction, it is possible to form the third and fourth wiring patterns by dividing them among two or more insulation layers. This enables the light emitting elements to be mounted in the insulation substrate in high density.
(10) In the metal base wiring board of (1), the recesses may be formed at regular intervals.
   With the above-described construction, the light emitting source can emit light beams being even in brightness when light emitting elements of the same output are mounted in the recesses.
(11) In the metal base wiring board of (1), the recesses may be circular in a plane view, and are ranging from 0.5 mm to 2.0 mm inclusive in diameter.
(12) In the metal base wiring board of (2), the recesses may become smaller in diameter on a layer-to-layer basis as the recesses are closer to the metal base.
(13) A metal base wiring board for retaining light emitting elements, which as such is not claimed here, comprises: an insulation substrate including a wiring pattern formed in a front surface thereof to interconnect the light emitting elements having been mounted therein; and a metal base attached to a rear surface of the insulation substrate, where a heat conductive member, which has higher heat conductivity than the insulation substrate, is deposited between the metal base and a planned mounting position of the light emitting elements in the insulation substrate.
   With the above-described construction, when the light emitting elements generate heat as they emit light, the heat is transmitted to the metal base on the rear side of the insulation substrate via the heat conductive member. This enables the heat to be effectively released during light emission.
(14) In the metal base wiring board of (13), the insulation substrate may have a single layer structure composed of one insulation layer, and the heat conductive member is embedded in a rear surface of the insulation substrate.
(15) In the metal base wiring board of (13), the insulation substrate may have a multi-layer structure composed of a plurality of insulation layers, and the heat conductive member is deposited at, at least, one position that is either in one of the plurality of insulation layers or between adjacent insulation layers.
(16) In the metal base wiring board of (15), the wiring pattern may be formed in a top layer and at least one of the remaining layers of the plurality of insulation layers.
   With the above-described construction, it is possible to divide a wiring pattern among a plurality of insulation layers. This enables the light emitting elements to be mounted the insulation substrate in high density.
(17) In the metal base wiring board of (13), the heat conductive member may be a metal film.
   With the above-described construction, excellent heat dissipation is provided since the metal film has high heat conductivity.
(18) In the metal base wiring board of (16), the wiring pattern may be formed in each of the plurality of insulation layers, and the heat conductive member constitutes part of a wiring pattern formed in one of the plurality of insulation layers, excluding a top layer thereof.
(19) In the metal base wiring board of (13), the heat conductive member may be thicker than the wiring pattern.
   With the above-described construction, the heat conductive member can be easily formed.
(20) In the metal base wiring board of (2), the insulation layers may be made of a material containing resin and an inorganic filler.
(21) In the metal base wiring board of (20), the inorganic filler may be made of one or more materials selected from a group consisting of silica, alumina, magnesia, beryllia, boron nitride, aluminum nitride, silicon carbide, boron carbide, titanium carbide, silicon nitride, and diamond.
   With the above-described construction, even if the metal base expands due to the heat generated as the light emitting elements emit light, the expansion in the vicinity of the front surface of the insulation substrate can be suppressed.
(22) In the metal base wiring board of (20), the wiring pattern may be formed in each of the plurality of insulation layers by a pattern transfer method.
   With the above-described construction, the wiring pattern can be formed easily.
(23) The above object of the present invention is also achieved by a light emitting source comprising: the metal base wiring board defined in (1); and light emitting elements having been mounted on bottom faces of the recesses in the metal base wiring board.
   With the above-described construction in which the light emitting elements are mounted on the bottom faces of the recesses, the distance between the light emitting elements and the metal base is reduced, thus improving the heat dissipation compared with the case where the light emitting elements are mounted on the front surface of the insulation substrate.
(24) The above object of the present invention is also achieved by a light emitting source comprising: the metal base wiring board defined in (5); and light emitting elements having been mounted on bottom faces of the recesses in the metal base wiring board, where each of the light emitting elements has a pair of electrodes in a rear surface thereof, and is mounted on a bottom face of a recess so that the electrodes are connected to the first wiring pattern.
(25) In the light emitting source of (24), each of the light emitting elements may be a sub-mount that includes: a substrate having a terminal; and a light emitting diode bare chip and/or a light emitting diode, each of which is mounted in a front surface of the substrate, and has an electrode in a rear surface thereof that is connected to the terminal of the substrate.
   With the above-described construction in which the light emitting elements are mounted on the bottom faces of the recesses, the distance between the light emitting elements and the metal base is reduced, thus improving the heat dissipation compared with the case where the light emitting elements are mounted on the front surface of the insulation substrate. Also, it is possible to divide a wiring pattern among a plurality of insulation layers. This enables the light emitting elements to be mounted the insulation substrate in high density.
(26) The above object of the present invention is also achieved by a light emitting source comprising: the metal base wiring board defined in (5); and light emitting elements having been mounted on bottom faces of the recesses in the metal base wiring board, where each of the light emitting elements has an electrode in each of front and rear surfaces thereof, the electrode in the front surface being connected to the second wiring pattern, and the electrode in the rear surface being connected to the first wiring pattern.
(27) In the light emitting source of (26), each of the light emitting elements may be a sub-mount that includes: a substrate having a terminal; and a light emitting diode bare chip and/or a light emitting diode, each of which is mounted in a front surface of the substrate, and has two electrodes that are respectively connected to terminals formed in front and rear surfaces of the substrate.
   With the above-described construction in which the light emitting elements are mounted on the bottom faces of the recesses, the distance between the light emitting elements and the metal base is reduced, thus improving the heat dissipation compared with the case where the light emitting elements are mounted on the front surface of the insulation substrate. Also, it is possible to divide a wiring pattern among a plurality of insulation layers. This enables the light emitting elements to be mounted the insulation substrate in high density.
(28) The above object of the present invention is also achieved by a light emitting source comprising: the metal base wiring board defined in (6); and light emitting elements having been mounted on bottom faces of the recesses in the metal base wiring board, where each of the light emitting elements has a pair of electrodes in a front surface thereof, the electrodes being connected to the wiring pattern by wire bonding.
(29) In the light emitting source of (28), each of the light emitting elements may be a sub-mount that includes: a substrate having a terminal; and a light emitting diode bare chip and/or a light emitting diode, each of which is mounted in a front surface of the substrate, and has a pair of electrodes in a front surface thereof that are connected to the terminal of the substrate.
   With the above-described construction in which the light emitting elements are mounted on the bottom faces of the recesses, the distance between the light emitting elements and the metal base is reduced, thus improving the heat dissipation compared with the case where the light emitting elements are mounted on the front surface of the insulation substrate.
(30) The above object of the present invention is also achieved by a light emitting source comprising: the metal base wiring board defined in (1); and light emitting elements having been mounted on bottom faces of the recesses in the metal base wiring board, where each of the light emitting elements has a pair of electrodes in a front surface thereof, the electrodes being connected to the wiring pattern by wire bonding.
(31) A light emitting source, which as such is not claimed here, comprises: the metal base wiring board defined in (7); and light emitting elements having been mounted on bottom faces of the recesses in the metal base wiring board, where each of the light emitting elements has a pair of electrodes in a front surface thereof, the electrodes being connected, by wire bonding, to the third and fourth wiring patterns, respectively.
   With the above-described construction in which the light emitting elements are mounted on the bottom faces of the recesses, the distance between the light emitting elements and the metal base is reduced, thus improving the heat dissipation compared with the case where the light emitting elements are mounted on the front surface of the insulation substrate.
(32) A light emitting source, which as such is not claimed here comprises: the metal base wiring board defined in (13); and light emitting elements having been mounted in the insulation substrate of the metal base wiring board.
   With the above-described construction, when the light emitting elements generate heat as they emit light, the heat is transmitted to the metal base on the rear side of the insulation substrate via the heat conductive member. This enables the heat to be effectively released during light emission.

Furthermore, a lighting apparatus or a display apparatus using the above-described light emitting source can effectively release the heat that is generated as the light emitting elements emit light.

### Brief Description Of The Drawings

Fig. 1 is a perspective view of an LED light source in Embodiment 1.
Fig.2 is a top plan view of the LED light source in Embodiment 1.
Fig. 3 is a top plan view of the lower insulation layer of the LED light source in Embodiment 1.
Fig. 4 is an enlarged detail of the portion A shown in Figs. 2 and 3, where part of the upper insulation layer 21 has been removed to show the lower insulation layer.
Fig. 5 is a sectional view taken substantially along line X-X of Fig. 4, viewed from a direction indicated by the arrows.
Fig. 6 illustrates the process of manufacturing the metal base wiring board.
Fig. 7A is an enlarged cross-sectional view of the LED light source in Variation 1.
Fig. 7B is an enlarged cross-sectional view of the LED light source in Variation 2.
Fig. 8A is an enlarged cross-sectional view of the LED light source in Variation 3.
Fig. 8B is an enlarged cross-sectional view of the LED light source in Variation 4.
Fig. 9 is a detailed view of an area in Embodiment 2 that corresponds to the area A in Embodiment 1 shown in Fig. 2.
Fig. 10 is a sectional view taken substantially along line 2X-2X of Fig. 9, viewed from a direction indicated by the arrows.
Fig. 11 is a top plan view of an area of the lower insulation layer which corresponds to the area shown in Fig. 9.
Fig. 12 is an enlarged cross-sectional view of the LED light source in Variation 5.
Fig. 13 is a top plan view of a metal base wiring board in Embodiment 3.
Fig. 14 is a top plan view of the lower insulation layer.
Fig. 15 is an enlarged detail of the portion B shown in Fig. 13, *where part of the upper insulation layer has been removed to show the lower insulation layer.
Fig. 16 is a sectional view taken substantially along line 3X-3X of Fig. 15, viewed from a direction indicated by the arrows.
Fig. 17 illustrates the process of manufacturing the metal base wiring board.
Fig. 18 is an enlarged top plan view of the metal base wiring board in Embodiment 4, where part of the upper insulation layer has been removed to show the lower insulation layer.
Fig. 19 is a sectional view of an LED light source having a single insulation layer made of a composite material.
Fig. 20A is an enlarged cross-sectional view of the LED light source in Variation 7.
Fig. 20B is an enlarged cross-sectional view of the LED light source in Variation 8.
Fig. 21 is a perspective view showing an LED light source that includes a lens plate and a reflector.
Fig. 22 is an enlarged cross-sectional view of LED bare chips mounted in the metal base wiring board.
Fig. 23 is an enlarged cross-sectional view of the LED light source in Variation 10.
Fig. 24 is an enlarged cross-sectional view of the LED light source in Variation 11.
Fig. 25 illustrates a process of manufacturing the metal base wiring board which is different from the process in Embodiment 1.
Fig. 26A is an enlarged cross-sectional view of the LED light source in Variation 13.
Fig. 26B is an enlarged cross-sectional view of the LED light source in Variation 14.
Fig. 27 shows an example of a lighting apparatus using the LED light source of Variation 9.

### Best Mode for Carrying Out the Invention

The following describes preferred embodiments of the present invention with reference to the attached drawings.

### Embodiment 1

The present embodiment will explain an LED light source that includes a metal base wiring board having recesses in a front surface thereof, where light emitting elements are mounted in the recesses. The metal base wiring board includes an insulation substrate composedofapluralityof insulation layers. The recesses are formed to pass through the insulation layers in the thickness direction of the insulation substrate downward, leaving part of the layers intact.

### 1. Construction of LED Light Source

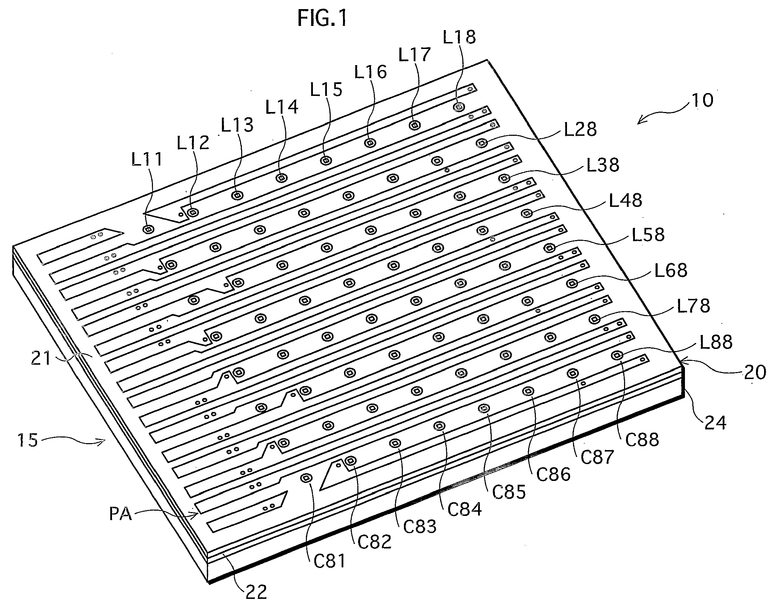

Fig. 1 is a perspective view of an LED light source in Embodiment 1.

An LED light source 10 (corresponding to "light emitting source" of the present invention) includes: a metal base wiring board 15 (corresponding to "metal base wiring board for retaining light emitting elements" of the present invention) whose upper (front) surface has a plurality of recesses that are circular in a plane view; and LED bare chips which are mounted in the recesses on the bottom faces thereof. The metal base wiring board 15 is composed of: an insulation substrate 20 composed of a plurality of insulation layers; and a metal base 24 that is attached to a rear surface of the insulation substrate 20.

In Embodiment 1, the recesses are orderly arranged in the front surface of the metal base wiring board 15. That is to say, the recesses are formed as independent entities in a matrix with 8 rows and 8 columns at substantially equal intervals in each direction of the rows and columns. The recesses are denoted by Cnm ("n" indicating an ordinal number of the row, and "m" an ordinal number of the column, "n" and "m" each being an integer ranging from "1" to "8"), and the LED bare chips mounted in the recesses Cnm are denoted by Lnm ("n" indicating an ordinal number of the row, "m" an ordinal number of the column, "n" and "m" each being an integer ranging from "1" to "8") that corresponds to Cnm.

The insulation substrate 20, having a two-layer structure, is a stack of insulation layers 21 and 22 which are both made of a material containing thermosetting resin and inorganic fillers. It should be noted here that the upper (front) layer of the two layers constituting the insulation substrate 20 is called an upper insulation layer 21, and the lower (rear) layer is called a lower insulation layer 22.

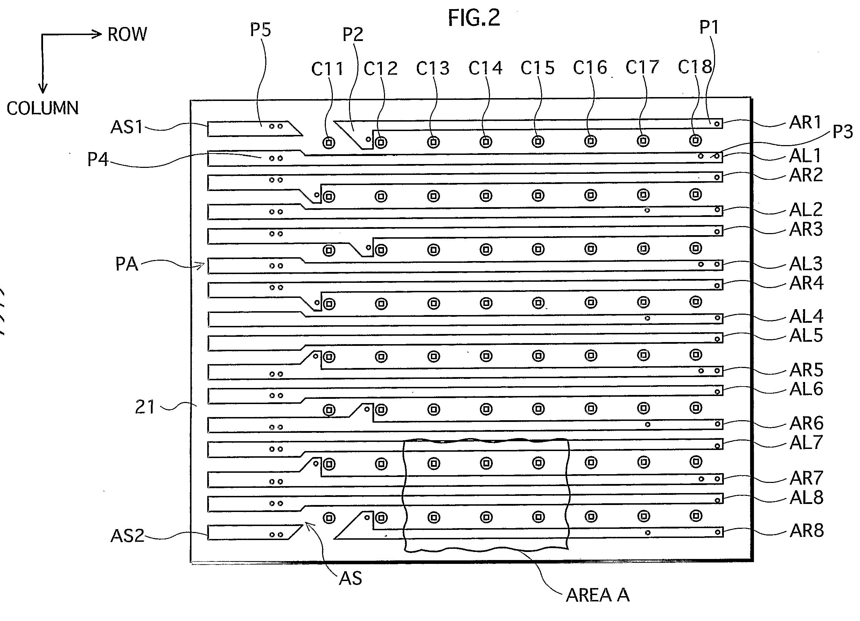

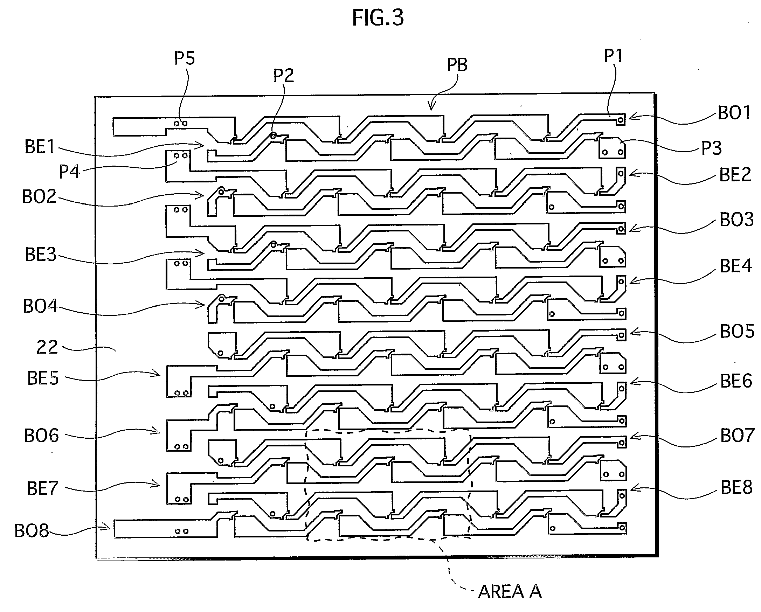

Fig. 2 is a top plan view of the LED light source 10. Fig. 3 is a top plan view of the lower insulation layer 22. It should be noted here that Fig. 2 shows only the upper insulation layer 21 which covers the lower insulation layer 22 of the insulation substrate 20.

As shown in Figs. 1 and 2, a wiring pattern PA (corresponding to "second wiring pattern" of the present invention) made of, for example, copper. (Cu) is formed on the front surface of the upper insulation layer 21. As shown in Fig. 3, a wiring pattern PB (corresponding to "first wiring pattern" of the present invention) made of, for example, copper (Cu) is formed on the front surface of the lower insulation layer 22.

In the present embodiment in which the LED bare chips Lnm are formed as a matrix with 8 rows and 8 columns, the wiring patterns PA and PB are designed so that LED bare chips in odd-numbered columns are connected in series for each row, that LED bare chips in even-numbered columns are also connected in series for each row, that the series of LED bare chips in odd-numbered columns is connected to the series of LED bare chips in even-numbered columns, and that the series of LED bare chips a row is connected to the series of LED bare chips of the next row, thus the LED bare chips being connected in series from row to row.

The LED bare chips Lnm are electrically connected to the wiring pattern PB formed on the front surface of the lower insulation layer 22.

As shown in Fig. 3, the wiring pattern PB is composed of an even-column chip connecting unit BEn and an odd-column chip connecting unit BOn, where "n" indicates an ordinal number of the row and is an integer ranging from "1" to "8". For example, the even-column chip connecting unit BE1 connects LED bare chips L12, L14, L16, and L18 in series, and the odd-column chip connecting unit BO1 connects LED bare chips L11, L13, L15, and L17 in series.

On the other hand, as shown in Fig. 2, the wiring pattern PA is composed of a column connecting unit ARn and a row connecting unit ALn, where "n" indicates an ordinal number of the row and is an integer ranging from "1" to "8". The column connecting unit ARn connects the even-column chip connecting unit BEn and the odd-column chip connecting unit BOn, which are formed in the lower insulation layer 22, for each row. For example, the column connecting unit AR1 connects the even-column chip connecting unit BE1 and the odd-column chip connecting unit BO1. The row connecting unit ALn connects the rows in the matrix in series in order. Both column connecting unit ARn and row connecting unit ALn are formed in a shape of a belt extending horizontally (in a direction of row).

The wiring pattern PA includes a power supply terminal unit AS for receiving power supply from an external power supply unit (not illustrated). The power supply terminal unit AS includes power supply terminals AS1 and AS2 for receiving the power supply. The power supply terminals AS1 and AS2 are respectively connected to the odd-column chip connecting units BO1 and BO8 in the first and eighth rows of the lower insulation layer 22.

Here, how the wiring patterns PA and PB are connected to each other will be explained briefly, using the first row of the matrix as an example with reference to Figs. 2 and 3. It should be noted here that in the present embodiment, the power supply terminals AS1 and AS2 are on the high potential side.

The even-column chip connecting unit BE1 and the odd-column chip connecting unit BO1 in the lower insulation layer 22 are connected to each other via the column connecting unit AR1 in the upper insulation layer 21. More particularly, the odd-column chip connecting unit BO1 is connected to the column connecting unit AR1 via a via hole (indicated by sign 0 in the drawing) formed at position P1 near an edge on the low potential side. Also, the even-column chip connecting unit BE1 is connected to the column connecting unit AR1 via a via hole formed at position P2 near an edge on the high potential side.

The even-column chip connecting unit BE1 in the first row is connected to the even-column chip connecting unit BE2 in the second row via the row connecting unit AL1. More particularly, the even-column chip connecting unit BE1 is connected to the row connecting unit AL1 via the via holes formed at position P3 near an edge on the low potential side. Also, the even-column chip connecting unit BE2 is connected to the row connecting unit AL1 via a via hole formed at position P4 near an edge on the high potential side.

The power supply terminal AS 1 is connected to the odd-column chip connecting unit BO1 in the first row via the via holes formed at position P5 near an edge on the high potential side. In this way, LED bare chips Lnm (n is an integer ranging from "1"' to "4") in the first row through the fourth row of the lower insulation layer 22 are connected in series. In a similar manner, LED bare chips Lnm (n is an integer ranging from "5" to "8") in the fifth row through the eighth row of the lower insulation layer 22 are connected in series.

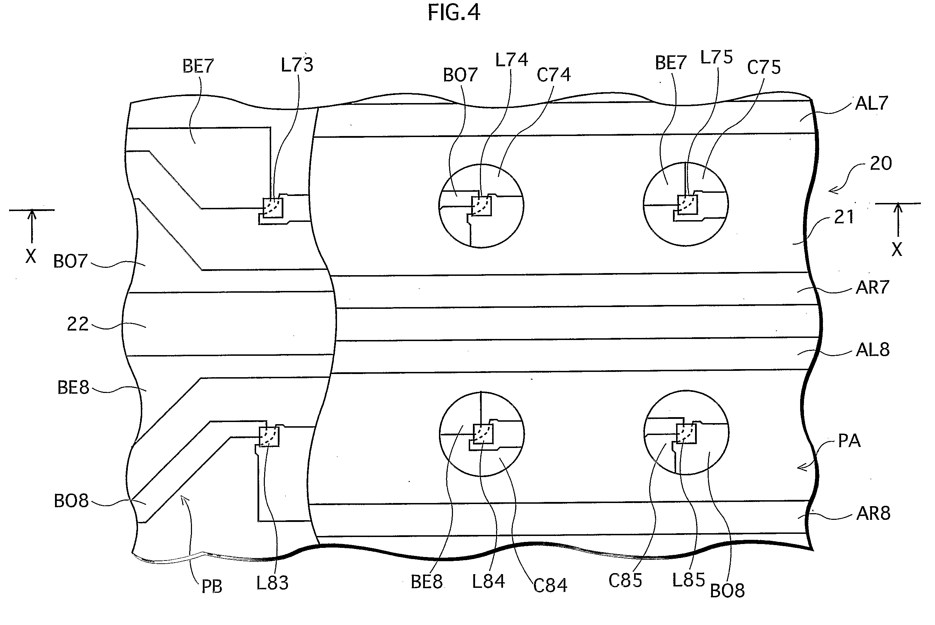

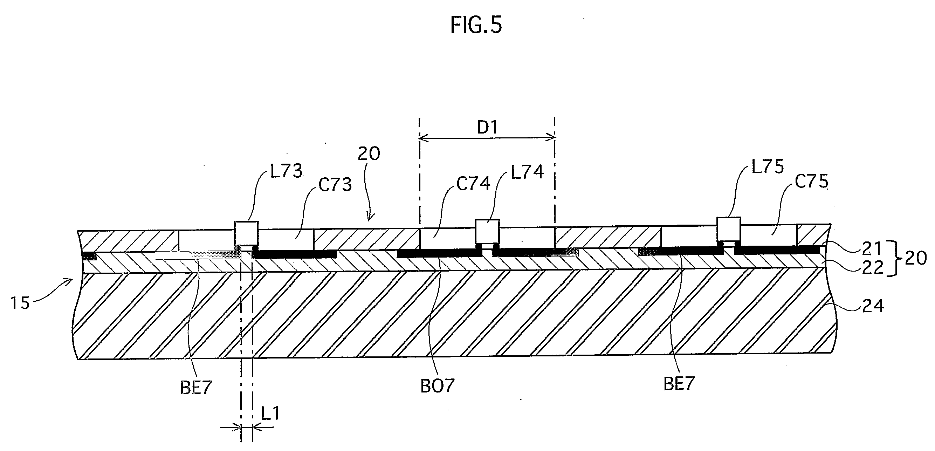

Fig. 4 is an enlarged detail of the portion A shown in Figs. 2 and 3, where part of the upper insulation layer 21 has been removed to show the lower insulation layer 22 (the left-hand side of Fig. 4). Fig. 5 is a sectional view taken substantially along line X-X of Fig. 4, viewed from a direction indicated by the arrows.

As shown in Fig. 5, the recesses C73, C74, and C75 are formed by removing certain portions of the upper insulation layer 21 in the shape of circles in a plane view to reveal the front surface of the lower insulation layer 22. That is to say, the bottom faces of the recesses C73, C74, and C75 are part of the front surface of the lower insulation layer 22.

As shown in Fig. 4, the LED bare chips L74, L75, L84, and L85 are respectively mounted in the recesses C74, C75, C84, and C85 whose bottom faces are the front surface of the lower insulation layer 22 where BE7, BO7, BE8, and BO8 of the wiring pattern PB are formed, respectively.

The LED bare chips Lnm used in the present embodiment are what is called blue LED bare chip, and are made of AlInGaN. The LED bare chips Lnm are single-sided electrodes, and their lower (rear) surface has a p-type electrode and an n-type electrode. The LED bare chips Lnm are mounted by flip-chip mounting. It should be noted here that hereinafter, single-sided electrodes whose upper (front) surface has both types of electrodes are referred to as front surface electrode type, and single-sided electrodes whose lower (rear) surface has both types of electrodes are referred to as rear surface electrode type.

Each LED bare chip Lnm is mounted at approximately the center of a recess Cnm in a plane view.

Each p-type electrode of the LED bare chips Lnm is connected to the high potential side of the wiring pattern PB revealed in the recess, and each n-type electrode is connected to the low potential side of the wiring pattern PB revealed in the recess.

The metal base 24, having higher heat conductivity than the insulation layers 21 and 22, releases heat that is generated as the LED bare chips Lnm emit light. The metal base 24 also reinforces the insulation substrate 20.

According to the construction of the present embodiment described above, only the lower insulation layer 22 exists between the LED bare chips Lnm and the metal base 24.

As a result, though the metal base wiring board 15 includes the insulation substrate 20 that is composed of insulation layers 21 and 22, the heat generated as the LED bare chips Lnm emit light is transmitted to the metal base 24 via the lower insulation layer 22, and is released from the metal base 24. With this construction, the insulation layer, which has low heat conductivity, has approximately half the thickness of the insulation substrate 20, thus drastically improving the heat dissipation. This prevents the LED bare chips Lnm from decreasing in the luminous efficiency or life.

Also, the LED bare chips Lnm can be mounted with ease by flip-chip mounting on the bottom faces of the recesses Cnm so as to be electrically connected to the wiring pattern PB directly.

Furthermore, the LED light source 10 contains the metal base wiring board 15 that includes the multi-layer insulation substrate 20 composed of the upper and lower insulation layers 21 and 22. This construction enables the LED bare chips Lnm to be mounted with high density on the insulation substrate by forming the wiring pattern on the two insulation layers, making full use of the multi-layer structure. This cannot be achieved by a single-layer insulation layer since it does not have enough area to cover all the desired wiring pattern observing the wiring pattern rules.

If, with such multi-layer structure, the LED bare chips were formed on top of the insulation substrate, the LED bare chips and the metal base 24 may be separated from each other to an unsatisfactory level. However, since the LED bare chips Lnm are mounted in the recesses Cnm whose bottom faces are the front surface of the lower insulation layer 22, the distance between the LED bare chips Lnm and the metal base 24 is equal to the thickness of the lower insulation layer 22.

Accordingly, the heat generated as the LED bare chips Lnm emit light is transmitted to the metal base 24 via the lower insulation layer 22, and is released from the metal base 24. The performance in regard with the heat dissipation is approximately the same as a metal base wiring board having a single-layered structure.

Also, since the LED bare chips Lnm are mounted in the recesses Cnm, it is possible to reduce the thickness of the LED light source 10.

### 2. Embodiment of LED Light Source

An embodiment of the LED light source 10 will be described. The upper and lower insulation layers 21 and 22 constituting the insulation substrate 20 are approximately 0.1 mm thick, respectively. The upper and lower insulation layers 21 and 22 are made of what is called alumina composite material in which alumina is used as the inorganic filler and epoxy resin is used as the thermosetting resin. The metal base 24 is made using an aluminum plate approximately 1 mm thick.

Each LED bare chip Lnm is approximately 300 µm square and 100 µm high. The LED bare chips Lnm are mounted on the insulation substrate 20 with high density in a matrix so that the center distance between each LED bare chip Lnm is approximately 2.5 mm in both directions of row and column.

The recesses Cnm are, as shown in Fig. 4, circular in a plane view, and the diameter of the recesses (indicated by "D1" Fig. 5) is 0.5 mm. This is the minimum diameter to enclose the LED bare chip Lnm that is 300 µm square. However, from the viewpoint of achieving the high-density mounting, it is preferable that the recess diameter is as small as possible since increase of the recess diameter D1 leads to increase of the distance between the mounted LED bare chips Lnm. A distance L1 between the wiring pattern PB connected to the n-type electrode and the wiring pattern PB connected to the p-type electrode for each LED bare chip Lnm is approximately 50 µm (see Fig. 5). 3. Metal Base Wiring board Manufacturing Process

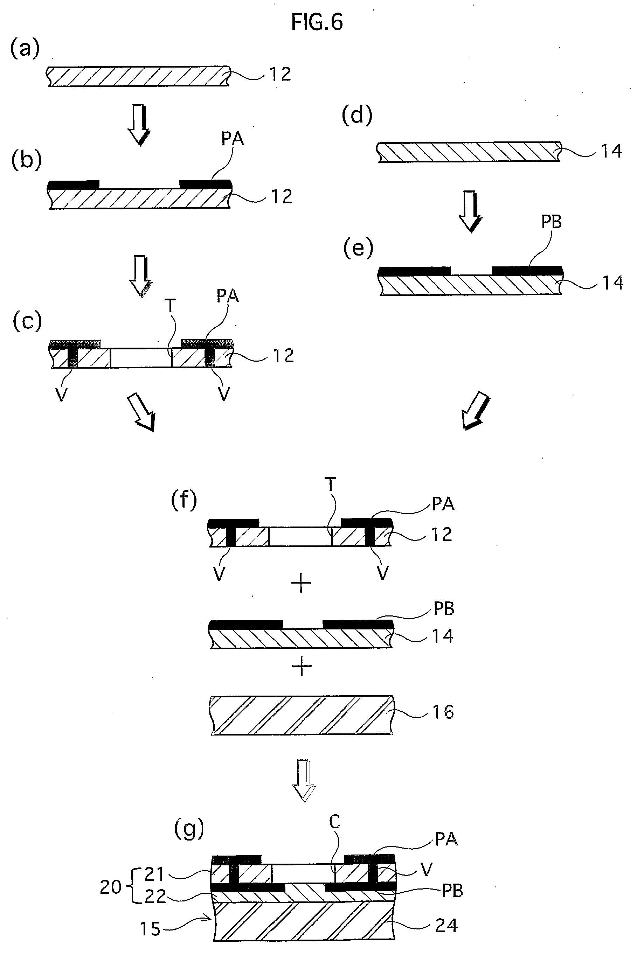

Fig. 6 illustrates the process of manufacturing the metal base wiring board. The manufacturing of the metal base wiring board on which the LED bare chips are to be mounted will be described briefly with reference to Fig. 6.

First, the upper insulation layer 21 production process will be described.

### <Step (a)>

An insulation plate 12 that has not been cured fully is prepared for the upper insulation layer 21.

### <Step (b) >

A copper foil as a material of the wiring pattern PA is attached to the front surface of the insulation plate 12. Unnecessary portions of the copper foil are then removed by etching, leaving the portions constituting the wiring pattern PA. In this way, the wiring pattern PA is formed on the front surface of the insulation plate 12.

### <Step (c)>

Through holes are then opened by stamping in the insulation plate 12, where through holes T are used for the recesses, and other through holes are used for via holes V. The through holes for via holes V are then filled with a conductive material to complete the via holes V so that they can electrically connect the wiring pattern PA to the wiring pattern PB of the lower insulation layer 22.

It should be noted here that the two types of through holes are formed at the same time in one step.

Secondly, the lower insulation layer 22 production process will be described.

### <Step (d)>

An insulation plate 14 that has not been cured fully is prepared for the lower insulation layer 22.

### <Step (e)>

A copper foil as a material of the wiring pattern PB is attached to the front surface of the insulation plate 14. Unnecessary portions of the copper foil are then removed by etching, leaving the portions constituting the wiring pattern PB. In this way, the wiring pattern PB is formed on the front surface of the insulation plate 14.

Finally, the process of attaching a metal plate to the insulation plates will be described.

### <Step (f)>

The insulation plate 12 is placed on the insulation plate 14 so that both upper (front) surfaces of these plates on which the wiring patterns are formed face upward. The insulation plates 12 and 14 are then placed on a metal plate 16 for the metal base so that the lower (rear) surface of the insulation plate 14 (the surface on which the wiring pattern is not formed) faces the metal plate.

### <Step (g)>

The three types of plates that have been put together in this way are then attached to each other by application of pressure and heat to cure the insulation plates 12 and 14.

This completes the metal base wiring board 15 composed of the insulation substrate 20 and the metal base 24, where the insulation substrate 20 is composed of the upper and lower insulation layers 21 and 22. Concurrently with this, the recesses C are formed at the positions of the through holes T.

The LED light source is then completed after the LED bare chips are mounted in the recesses C of the completed metal base wiring board 15, by flip-chip mounting.

It should be noted here that in the present embodiment, a semicured insulation plate is cured, and the cured insulation plate is used as an insulation layer. Also, if the through holes T formed in the insulation plate 12 are crushed while the plates are attached to each other by the application of pressure and heat, the pressurizer may have projections corresponding to the through holes T to secure the holes.

With the above describedprocess in which (i) the insulation plate 12 having the wiring pattern PA and through holes T and (ii) the insulation plate 14 having the wiring pattern PB are put together and then attached together by application of pressure and heat, the recesses C can be formed easily on the front surface side of the insulation substrate 20, and the front surface of the lower insulation layer 22 can be used as the bottom faces of the recesses.

Further, as shown in Fig. 3, although the wiring pattern PB is formed in approximately the entire area of the front surface of the lower insulation layer 22, the odd-column chip connecting unit BOn and the even-column chip connecting unit BEn are separated from each other. This means that the areas except for the wiring pattern PB of the upper (front) surface of the lower insulation layer 22 are directly attached to the rear surface of the upper insulation layer 21. This enables the two layers to be attached together tightly.

In the present embodiment, semicured insulation plates 12 and 14 are put together, and then the insulation plates 12 and 14 are cured by application of pressure and heat. However, the metal plate 16 may be attached to the semicured insulation plate 14 for the lower insulation layer 22 in advance by application of pressure and heat, and then the semicured insulation plate 12 for the upper insulation layer 21 may be attached to the completed lower insulation layer 22 by application of pressure and heat. With such an arrangement, the wiring pattern PB has less asperities. That is to say, such an arrangement improves the evenness on the surface of the wiring pattern PB on which the LED bare chips Lnm are mounted. As a result, such an arrangement improves the secureness of the LED bare chips Lnm mounted on the wiring pattern PB, and enables all the light emitting layers of the mounted LED bare chips Lnm to be oriented towards substantially a same direction.

### 4. Supplements and Variations

### <1. Mounting LED bare Chips>

The LED bare chips Lnm used in the above-described embodiment are of what is called a rear surface electrode type in which electrodes are held at the lower (rear) surface thereof. However, other types of LED bare chips may be used instead. The following describes the cases using two of the other types of LED bare chips: (a) double surface electrode type; and (b) front surface electrode type.

### A. Mounting Double Surface Electrode Type LED bare Chips

This section will explain about an LED light source in which double surface electrode type LED bare chips, which have electrodes in both upper (front) and lower (rear) surfaces thereof, are mounted on the metal base wiring board. Here, two cases will be explained as Variations 1 and 2, respectively. In both variations, the electrodes in the rear surface of the LED bare chips are connected to the wiring pattern of the lower insulation layer. In Variation 1, the electrodes in the front surface of the LED bare chips are connected to the wiring pattern of the lower insulation layer; and in Variation 2, the electrodes in the front surface of the LED bare chips are connected to the wiring pattern of the upper insulation layer.

The double surface electrode type LED bare chips may be, for example, AlInGaP base.

### i) Connecting Electrodes in Front Surface of LED Bare Chips to Lower Insulation Layer (Variation 1)

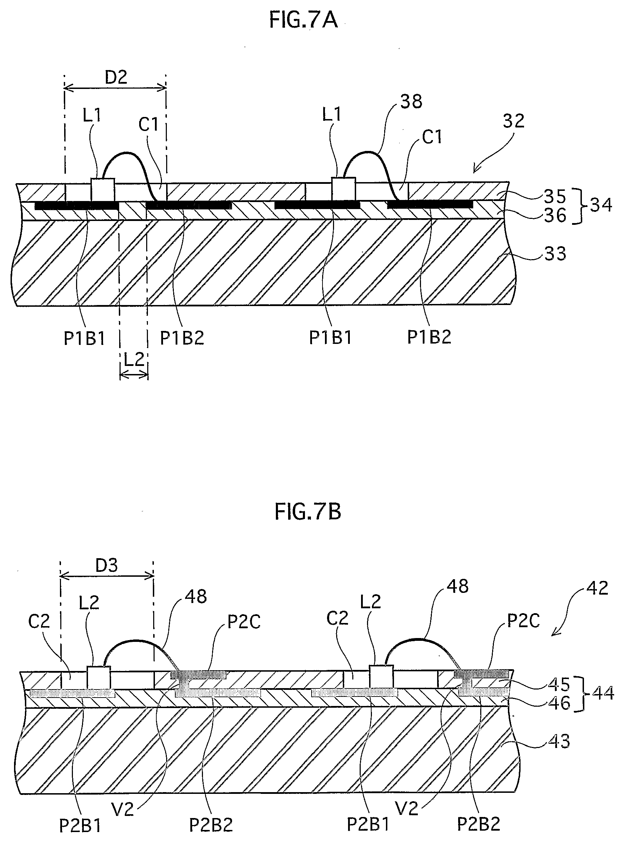

Fig. 7A is an enlarged cross-sectional view showing the connection of electrodes in the front surface of the double surface electrode type LED bare chips to the wiring pattern of the lower insulation layer.

As shown in Fig. 7A, a metal base wiring board 32 has a metal base 33 and an insulation substrate 34 attached to the front surface of the metal base 33. The insulation substrate 34 has a multi- (two-) layer structure as is the case with Embodiment 1, and includes an upper insulation layer 35 and a lower insulation layer 36. Also, as is the case with Embodiment 1, the upper insulation layer 35 has recesses C1 whose bottom faces are the front surface of the lower insulation layer 36.

A wiring pattern (not illustrated) corresponding to the wiring pattern PA is formed in the front surface of the upper insulation layer 35. Also, wiring patterns P1B1 and P1B2 corresponding to the wiring pattern PB are formed in the front surface of the lower insulation layer 36. The recesses C1 are circular in a plane view, as in Embodiment 1.

Part of the wiring patterns P1B1 and P1B2 is exposed in the recesses C1. LED bare chips L1 are connected to the part of the wiring patterns P1B1 and P1B2 exposed in the recesses

C1.

More specifically, electrodes in the rear surface of the LED bare chips L1 are electrically connected to the wiring pattern P1B1 via conductive paste (that is, by die bonding), and electrodes in the front surface of the LED bare chips L1 are electrically connected to the wiring pattern P1B2 via wires 38 made of gold or the like (that is, by wire bonding).

The distance L2 (see Fig. 7A) between the wiring patterns P1B1 and P1B2 exposed in the recesses C1 should be at least approximately 0.25 mm, and the diameter D2 (see Fig. 7A) of the recesses C1 should be at least approximately 1.0 mm.

### ii) Connecting Electrodes in Front Surface of LED Bare Chips to Upper Insulation Layer (Variation 2)

Fig. 7B is an enlarged cross-sectional view showing the connection of electrodes in the front surface of the double surface electrode type LED bare chips to the wiring pattern of the upper insulation layer.

As shown in Fig. 7B, a metal base wiring board 42 has a metal base 43 and an insulation substrate 44 attached to the front surface of the metal base 43. The insulation substrate 44 has a multi- (two-) layer structure as is the case with Embodiment 1, and includes an upper insulation layer 45 and a lower insulation layer 46. Also, as is the case with Embodiment 1, the upper insulation layer 45 has recesses C2 whose bottom faces are the front surface of the lower insulation layer 46.

Wiring patterns P2B1 and P2B2 corresponding to the wiring patterns P1B1 and P1B2 of Variation 1 are formed in the front surface of the lower insulation layer 46. Either the wiring pattern P2B1 or P2B2, for example, the wiring pattern P2B1 is partially exposed in the recesses C2.

A wiring pattern (not illustrated) corresponding to the wiring pattern PA is formed in the front surface of the upper insulation layer 45. In addition to the wiring pattern, a pad P2C connected to the wiring pattern P2B2 of the lower insulation layer 46 via a via hole V2 is formed in the front surface of the upper insulation layer 45.

Electrodes in the rear surface of LED bare chips L2 are electrically connected to the wiring pattern P2B1 via silver paste (that is, by die bonding), and electrodes in the front surface of the LED bare chips L2 are electrically connected to the pad P2C via wires 48 made of gold or the like (that is, by wire bonding).

In contrast to Variation 1, the diameter D3 (see Fig. 7B) of the recesses C2 can be reduced to up to approximately 0.5 mm since electrodes in the front surface of the LED bare chips L2 are connected to the pad P2C of the upper insulation layer 45.

In the case of Variation 2, when the LED bare chips L2 are attached to the bottom faces of the recesses C2 by die bonding, the silver paste for the die bonding does not flow out from the recesses C2, thus preventing the silver paste from sticking to the front surface of the metal base wiring board 42.

Also, the curvature of the wires 48 is smaller than that of the wires 38. This prevents the wires 48 from being detached or broken and enables the wires 48 to be attached efficiently. B. Mounting Front Surface Electrode Type LED bare Chips

This section will explain about an LED light source in which front surface electrode type LED bare chips, which have electrodes in the front surface thereof, are mounted on the metal base wiring board. Here, two cases will be explained as Variations 3 and 4, respectively. In Variation 3, the electrodes in the front surface of the LED bare chips are connected to the wiring pattern of the lower insulation layer; and in Variation 4, the electrodes in the front surface of the LED bare chips are connected to the wiring pattern of the upper insulation layer.

The front surface electrode type LED bare chips may be, for example, AlInGaN base.

### i) Connecting Electrodes in Front Surface of Bare Chips to Lower Insulation Layer (Variation 3)

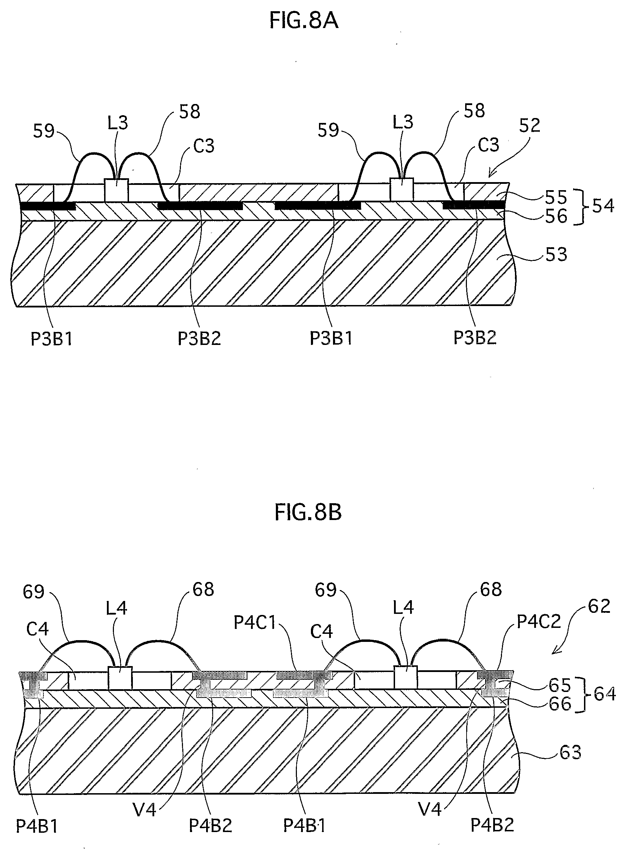

Fig. 8A is an enlarged cross-sectional view showing the connection of electrodes in the front surface of the front surface electrode type LED bare chips to the wiring pattern of the lower insulation layer.

As shown in Fig. 8A, a metal base wiring board 52 has a metal base 53 and an insulation substrate 54 attached to the front surface of the metal base 53. The insulation substrate 54 has a multi- (two-) layer structure as is the case with Embodiment 1, and includes an upper insulation layer 55 and a lower insulation layer 56. Also, as is the case with Embodiment 1, the insulation substrate 54 has recesses C3 whose bottom faces are the front surface of the lower insulation layer 56.

A wiring pattern (not illustrated) corresponding to the wiring pattern PA is formed in the front surface of the upper insulation layer 55. Also, wiring patterns P3B1 and P3B2 corresponding to the wiring pattern PB are formed in the front surface of the lower insulation layer 56.

Part of the wiring patterns P3B1 and P3B2 is exposed in the recesses C3. LED bare chips L3 are connected to the part of the wiring patterns P3B1 and P3B2 exposed in the recesses C3.

More specifically, one electrode in the front surface of an LED bare chip L3 is electrically connected to the wiring pattern P3B1 via a wire 59 (that is, by wire bonding), and another electrode in the front surface of the LED bare chip L3 is electrically connected to the wiring pattern P3B2 via a wire 58 (that is, by wire bonding).

### ii) Connecting Electrodes in Front Surface of Bare Chips to Upper Insulation Layer (Variation 4)

Fig. 8B is an enlarged cross-sectional view showing the connection of electrodes in the front surface of the front surface electrode type LED bare chips to the wiring pattern of the upper insulation layer.

As shown in Fig. 8B, a metal base wiring board 62 has a metal base 63 and an insulation substrate 64 attached to the front surface of the metal base 63. The insulation substrate 64 has a multi- (two-) layer structure as is the case with Embodiment 1, and includes an upper insulation layer 65 and a lower insulation layer 66. Also, as is the case with Embodiment 1, the insulation substrate 64 has recesses C4 whose bottom faces are the front surface of the lower insulation layer 66.

Wiring patterns P4B1 and P4B2 corresponding to the wiring pattern PB of Embodiment 1 are formed in the front surface of the lower insulation layer 66. It should be noted here that in contrast to Embodiment 1 and Variations 1-3, the wiring patterns P4B1 and P4B2 are not exposed in the recesses C4.

A wiring pattern (not illustrated) corresponding to the wiring pattern PA is formed in the front surface of the upper insulation layer 65. In addition to the wiring pattern, pads P4C1 and P4C2 that are respectively connected to the wiring patterns P4B1 and P4B2 through the medium of via holes V4 are formed in the front surface of the upper insulation layer 65.

More specifically, one electrode in the front surface of an LED bare chip L4 is electrically connected to the pad P4C1 via a wire 69 (that is, by wire bonding), and another electrode in the front surface of the LED bare chip L4 is electrically connected to the pad P4B2 via a wire 68 (that is, by wire bonding) . The diameter of the recesses C4 can be smaller than that of the recesses C3 of Variation 3 since electrodes in the front surface of the LED bare chips L4 are connected to the upper insulation layer 65. This enables larger areas of the front surface of the upper insulation layer 65 to be used for the wiring pattern than in Variation 3.

### iii) Others

In Variations 3 and 4, both electrodes of each of the LED bare chips L3 and L4 are connected to the upper or lower insulation layer. However, one electrode of each of the LED bare chips L3 and L4 may be connected to the upper insulation layer and another electrode may be connected to the lower insulation layer. It should be noted here that in the present document, it is supposed that the pads are included in the wiring patterns.

### Embodiment 2

Embodiment 2 is different from Embodiment 1 in that the recesses formed in the metal base wiring board pass through the insulation substrate and reach the metal base.

### 1. Construction of LED Light Source

As is the case with Embodiment 1, an LED light source in Embodiment 2 includes a metal base wiring board and a plurality of LED bare chips which are mounted in the metal base wiring board. Also, recesses are formed in the front surface of the metal base wiring board in a matrix with 8 rows and 8 columns, and the LED bare chips are mounted on the bottom faces of the recesses, respectively.

In Embodiment 2, the recesses are denoted by 2Cnm, and the LED bare chips are denoted by 2Lnm.

In Embodiment 1, the bottom faces of the recesses Cnm are the front surface of the lower insulation layer 22 of the insulation substrate 20, while in Embodiment 2, the bottom faces of the recesses 2Cnm are the front surface of the metal base. That is to say, the recesses 2Cnm pass through the insulation layers and reach the metal base. Embodiment 2 is the same as Embodiment 1 in terms of the positions of the recesses 2Cnm, the construction of the metal base wiring board or the like. Such commonalities of the embodiments will be omitted from the following explanation.

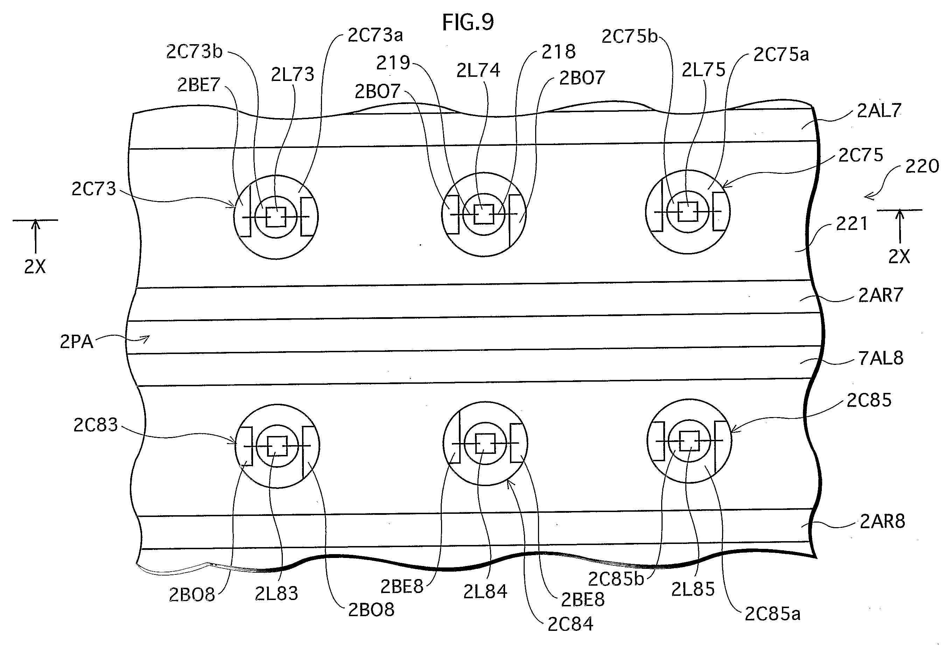

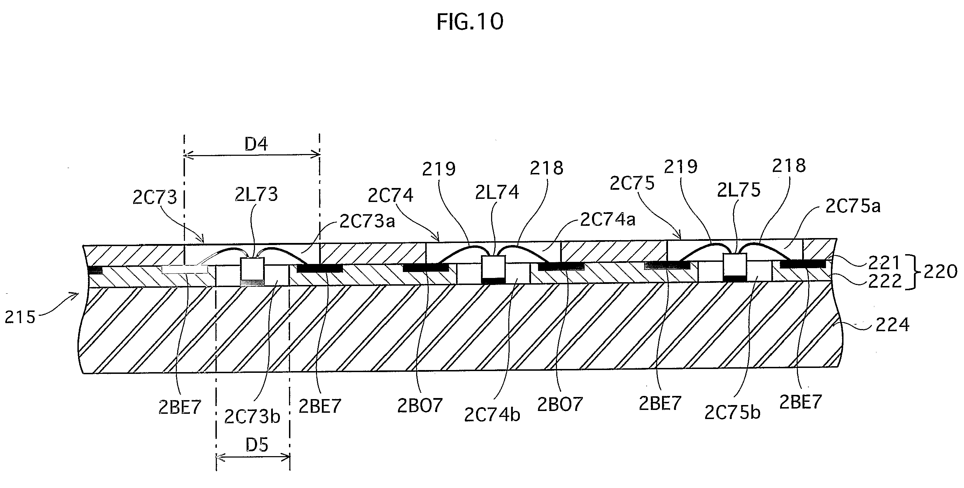

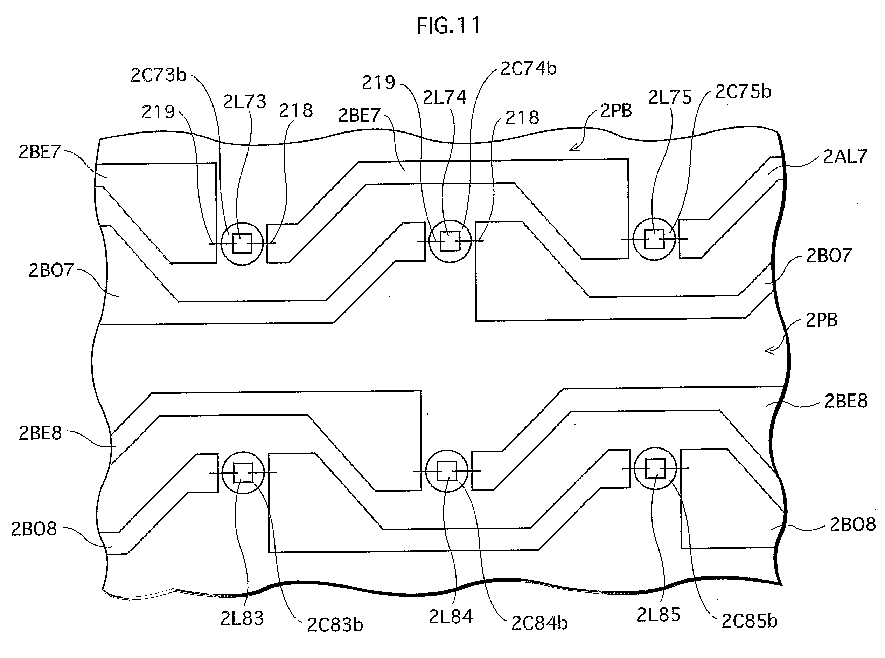

Fig. 9 is a detailed view of the area A shown in Fig. 2. Fig. 10 is a sectional view taken substantially along line 2X-2X of Fig. 9, viewed from a direction indicated by the arrows. Fig. 11 is a top plan view of an area of the lower insulation layer 22 which corresponds to the area shown in Fig. 9. The area A includes six recesses 2Cnm: recesses 2C73, 2C74, 2C75, 2C83, 2C84, and 2C85. The recesses 2Cnm in the other area have the same structure, and the LED bare chips 2Lnm are mounted in the recesses in the same manner as in the area A.

The present embodiment will be described with reference to Figs. 9-11.

As shown in Figs. 9-11, a metal base wiring board 215 has a metal base 224 and an insulation substrate 220. The insulation substrate 220 includes an upper insulation layer 221 and a lower insulation layer 222. The insulation substrate 220 has recesses 2Cnm whose bottom faces are the front surface of the metal base 224.

As shown in Fig. 10, the recesses 2C73-2C75 pass through the insulation substrate 220 and the bottom faces of the recesses 2C73-2C75 are the front surface of the metal base 224.

As shown in Figs. 9-11, the recesses 2C73-2C75 and 2C83-2C85 are respectively composed of: upper openings 2C73a-2C75a and 2C83a-2C85a formed in the upper insulation layer 221; and lower openings 2C73b-2C75b and 2C83b-2C85b formed in the lower insulation layer 222.

As is the case with the insulation substrate 20 of Embodiment 1, wiring patterns 2PA and 2PB are formed in the front surfaces of the upper and lower insulation layers 221 and 222, respectively. It should be noted here that the wiring pattern 2PB corresponds to "third wiring pattern" of the present invention, and that the wiring pattern 2PA corresponds to "fourth wiring pattern" of the present invention.

The lower insulation layer 222 has the wiring pattern 2PB which is similar to the wiringpattern PB of Embodiment 1. However, the lower insulation layer 222 is different from the lower insulation layer 22 of Embodiment 1 in that its has the lower openings 2C73b-2C75b and 2C83b-2C85b in which the LED bare chips 2L73-2L75 and 2L83-2L85 are to be mounted, respectively.

As shown in Figs. 9-11, the upper openings 2C73a-2C75a and 2C83a-2C85a are larger than the lower openings 2C73b-2C75b and 2C83b-2C85b in diameter.

Also, as shown in Fig. 9, part of even-column chip connecting unit 2BE7 and odd-column chip connecting unit 2BO7 of the wiring pattern 2PB formed in the front surface of the lower insulation layer 222 is revealed by the upper openings 2C73a-2C75a, and part of even-column chip connecting unit 2BE8 and odd-column chip connecting unit 2BO8 is revealed by the upper openings 2C83a-2C85a.

As shown in Figs. 9-11, the LED bare chips 2L73-2L75 and 2L83-2L85 are mounted on the bottom faces of the recesses 2C73-2C75 and 2C83-2C85, namely mounted on part of the front surface of the metal base 224 exposed in ·the recesses.

TheLEDbare chips 2L73-2L75 and 2L83-2L85 are front surface electrode type and have two electrodes on the front surface thereof. The rear surface of the LED bare chips 2L73-2L75 and 2L83-2L85 is attached, by die bonding, to part of the front surface of the metal base 224 that corresponds to the bottom faces of the recesses 2C73-2C75 and 2C83-2C85. The two electrodes in the front surface of the LED bare chips 2L73-2L75 and 2L83-2L85 are electrically connected to the wiring pattern 2 PB (even-column chip connecting units 2BE7 and 2BE8 and odd-column chip connecting units 2BO7 and 2BO8) via wires 218 and 219, by wire bonding.

The front surface electrode type LED bare chips 2Lnm may be, for example, AlInGaN base, as is the case with Variations 3 and 4.

The metal base wiring board 215 used in the above-described LED light source includes (a) the metal base 224 on the rear side thereof and on the front side, (b) the insulation substrate 220 having recesses 2Cnm that pass through it in the thickness direction. The LED bare chips 2Lnm are mounted in the recesses 2Cnm directly on the front surface of the metal base 224 being the bottom faces of the recesses.

Although the metal base wiring board 215 is composed of two insulation layers 221 and 222, the heat, which is generated as the LED bare chips 2Lnm emit light, is transmitted directly to the metal base 224, and released from the metal base 224.

With the above-explained structure of the metal base wiring board in Embodiment 2 that transmits heat without passing the insulation layers that reduces the heat dissipation significantly, the LED light source of Embodiment 2 has a higher heat dissipation than that of Embodiment 1.

### 2. Embodiment of LED Light Source

An embodiment of the LED light source will be described.

Each LED bare chip 2Lnm is approximately 300 µm square and 100 µm high.

The recesses 2Cnm are, as shown in Fig. 9, circular in a plane view, and the diameters of the upper and lower openings 2Cnma and 2Cnmb (indicated respectively by "D4" and "D5" in Fig. 10) are 1.0 mm and 0.5 mm, respectively.

The diameter of the lower openings 2Cnmb should be at leas 0.44 mm to enclose the LED bare chip 2Lnm that is 300 µm square.

However, from the viewpoint of achieving the high-density mounting, it is preferable that the diameter D5 is as small as possible since increase of the diameter D5 leads to increase of the distance between the mounted LED bare chips 2Lnm.

The thickness of the upper and lower insulation layers 221 and 222, the material of the insulation substrate 220, and the material and thickness of the metal base 224 in Embodiment 2 are the same as those in Embodiment 1.

### 3. Metal Base Wiring Board Manufacturing Process

The metal base wiring board 215 in Embodiment 2 can be manufactured with the same method described in Embodiment 1.

In Embodiment 1, the through holes are formed only in the upper insulation layer. In Embodiment 2, through holes smaller than those for the upper insulation layer are formed in the insulation plate for the lower insulation layer. Then, as is the case with Embodiment 1, the insulation plates for the upper and lower insulation layers and the metal plate for the metal base are put together and attached together by application of pressure and heat.

### 4. Supplements and Variations

### <Mounting LED bare Chips>

In Embodiment 2, electrodes of the LED bare chips 2Lnm are connected to the wiring pattern 2PB (2BEn and 2BOn) of the lower insulation layer 222 by wire bonding (see Figs. 9-11). However, the electrodes may be connected to another insulation layer.

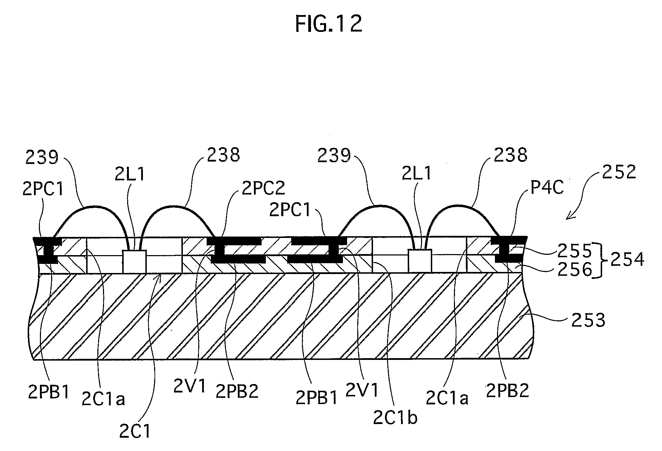

Fig. 12 is an enlarged cross-sectional view showing the connection of electrodes in the front surface of the LED bare chips to the wiring pattern of the upper insulation layer. This case is referred to as Variation 5.

As shown in Fig. 12, a metal base wiring board 252 has substantially the same structure as the metal base wiring board in Embodiment 2, and has recesses 2C1 that pass through the insulation substrate 254. As is the case with Embodiment 2, the insulation substrate 254 is composed of the upper and lower insulation layers 255 and 256.

Wiring patterns 2PB1 and 2PB2 corresponding to the wiring pattern 2PB of Embodiment 2 are formed in the front surface of the lower insulation layer 256. It should be noted here that the wiring patterns 2PB1 and 2PB2 are not exposed in the recesses 2C1.

A wiring pattern (not illustrated) corresponding to the wiring pattern 2PA is formed in the front surface of the upper insulation layer 255. In addition to the wiring pattern, pads 2PC1 and 2PC2 that are respectively connected to the wiring patterns 2PB1 and 2PB2 through the medium of via holes 2V1 are formed in the front surface of the upper insulation layer 255.

One electrode in the front surface of front surface electrode type LED bare chips 2L1 is electrically connected to the pad 2PC1 via a wire 239, and another electrode in the front surface of the LED bare chip 2L1 is electrically connected to the pad 2PC2 via a wire 238.

### Embodiment 3

Embodiment 3 of the present invention is a metal base wiring board that has light emitting elements on the front surface of an insulation substrate, the insulation substrate containing heat conductive members between the light emitting elements and a metal base.

### 1. Construction of LED Light Source

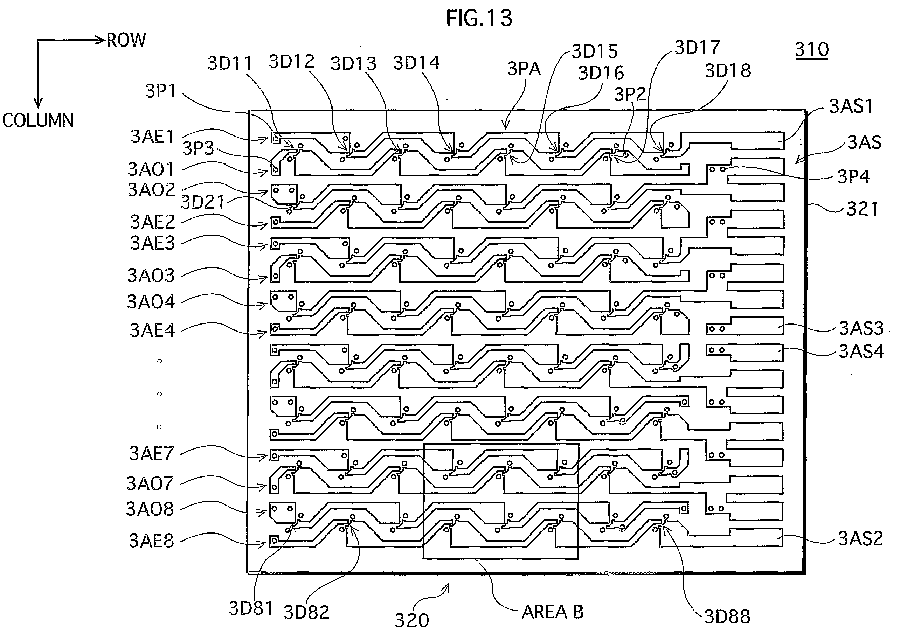

Fig. 13 is a top plan view of a metal base wiring board 13 in Embodiment 3.

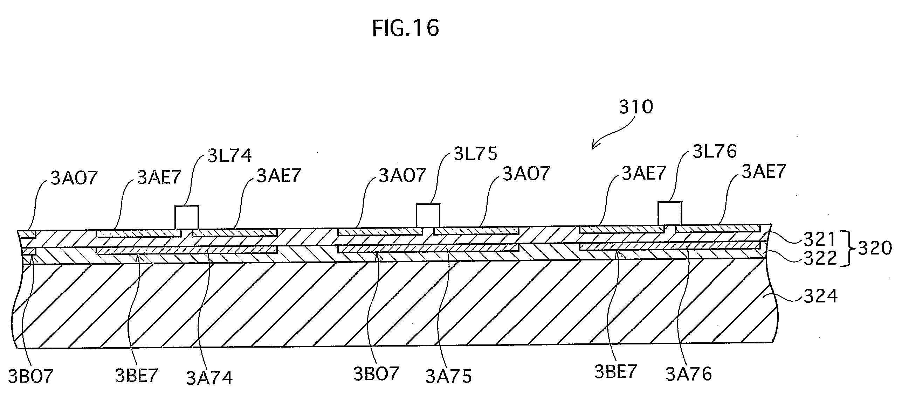

As is the case with Embodiments 1 and 2, the metal base wiring board 310 is composed of: an insulation substrate 320 composed of a plurality of insulation layers (two layers in the case of Embodiment 3, see Fig. 16) made of a material containing thermosetting resin and inorganic fillers, where wiring patterns made of copper (Cu) are formed on the front and rear surfaces of the insulation substrate 320; and a metal base 324 that is attached to a rear surface of the insulation substrate 320 (see Fig. 16).

As shown in Fig. 16, the insulation substrate 320 has an upper insulation layer 321 on the upper (front) side thereof, and a lower insulation layer 322 on the lower (rear) side. It should be noted here that Fig. 13 shows only the upper insulation layer 321 which covers the lower insulation layer 322 of the insulation substrate 320.

As is the case with Embodiments 1 and 2, 64 LED bare chips are orderly mounted on the front surface of the metal base wiring board 310 in a matrix with 8 rows and 8 columns. In Embodiment 3, the LED bare chips are denoted by 3Dnm ("n" indicating an ordinal number of the row, and "m" an ordinal number of the column, "n" and "m" each being an integer ranging from "1" to "8").

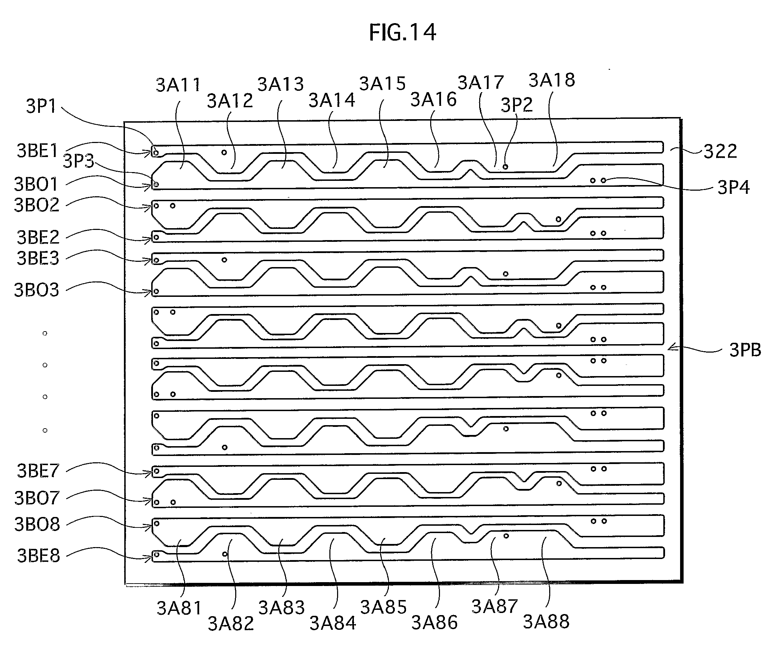

Fig. 14 is a top plan view of the lower insulation layer 322.

Wiring patterns 3PA and 3PB in the upper and lower insulation layers 321 and 322, shown in Figs. 13 and 14, are mainly formed to connect the LED bare chips in the odd-numbered columns and the LED bare chips in the even-numbered columns in series, respectively. Each of the wiring patterns 3PA and 3PB changes in direction between the fourth and fifth rows.

As shown in Fig. 13, the wiring pattern 3PA includes an even-column chip connecting unit 3AEn, an odd-column chip connecting unit 3AOn, and a power supply terminal unit 3AS, where "n" indicates an ordinal number of the row and is an integer ranging from "1" to "8". The even-column chip connecting unit 3AEn connects LED bare chips of even-numbered columns for each row (for example, 3D12, 3D14, 3D16, and 3D18 in the case of the first row) in series, and the odd-column chip connecting unit 3AOn connects LED bare chips of odd-numbered columns for each row (for example, 3D11, 3D13, 3D15, and 3D17 in the case of the first row). The power supply terminal unit 3AS is used for the LED bare chips in each row to receive power supply.

The even-column chip connecting unit 3AEn and odd-column chip connecting unit 3AOn make a pair for each row. They are shaped like a pair of belts with gears, and the gears are arranged to be in mesh.

As shown in Fig. 14, the wiring pattern 3PB of the lower insulation layer 322 includes an even-column chip connecting unit 3BEn and an odd-column chip connecting unit 3BOn that corresponds to the even-column chip connecting unit 3AEn and odd-column chip connecting unit 3AOn of the upper insulation layer 321, for each row, where "n" indicates an ordinal number of the row and is an integer ranging from "1" to "8".

Similar to those of the upper insulation layer 321, the even-column chip connecting unit 3BEn and the odd-column chip connecting unit 3BOn for each row are shaped like a pair of belts with gears that are in mesh.

Now, how the wiring patterns 3PA and 3PB are connected to each other will be explained briefly, using the first row of the matrix as an example with reference to Figs. 13 and 14.

It should be noted here that in the present embodiment, (i) power supply terminal 3AS1 connected to even-column chip connecting unit 3AE1 in the first row and (ii) power supply terminal 3AS2 connected to even-column chip connecting unit 3AE8 in the eighth row are on the high potential side.

Firstly, even-column chip connecting unit 3AE1 of the upper insulation layer 321 is connected to even-column chip connecting unit 3BE1 of the lower insulation layer 322 at position 3P1 near an edge on the low potential side. Also, the even-column chip connecting unit 3BE1 is connected to odd -column chip connecting unit 3AO1 of the upper insulation layer 321 at position 3P2 near an edge on the high potential side. With these connections, the even-column chip connecting unit 3AE1 and odd-column chip connecting unit 3AO1 in the upper insulation layer 321 are connected to each other in series.

Secondly, odd-column chip connecting unit 3AO1 of the upper insulation layer 321 is connected to odd-column chip connecting unit 3BO1 of the lower insulation layer 322 at position 3P3 near an edge on the low potential side. Also, the odd-column chip connecting unit 3BO1 is connected to odd -column chip connecting unit 3AO2 of the upper insulation layer 321 at position 3P4 near an edge on the high potential side. With these connections, the odd-column chip connecting unit 3AO1 and odd-column chip connecting unit 3AO2 of the second row in the upper insulation layer 321 are connected to each other in series.

In this way, the LED bare chips of the first row through the fourth row in the upper insulation layer 321 are connected to each other in series. The even-column chip connecting unit 3AE4 of the fourth row is connected to power supply terminal unit 3AS3 via even-column chip connecting unit 3BE4 of the lower insulation layer 322. It should be noted here that the wiring pattern 3PA in the upper insulation layer 321 and the wiring pattern 3PB in the lower insulation layer 322 are connected to each other, for example, through the medium of via holes.

With above-described construction, application of current to (i) power supply terminal unit 3AS1 located in the even-column chip connecting unit 3AE1 on the high potential side and (ii) power supply terminal unit 3AS3 located in the fourth row on the low potential side causes the LED bare chips of the first row through the fourth row to emit light. Similarly, application of current to (i) power supply terminal unit 3AS2 located in the even-column chip connecting unit 3AE8 on the high potential side and (ii) power supply terminal unit 3AS4 located in the fifth row on the low potential side causes the LED bare chips of the fifth row through the eighth row to emit light.

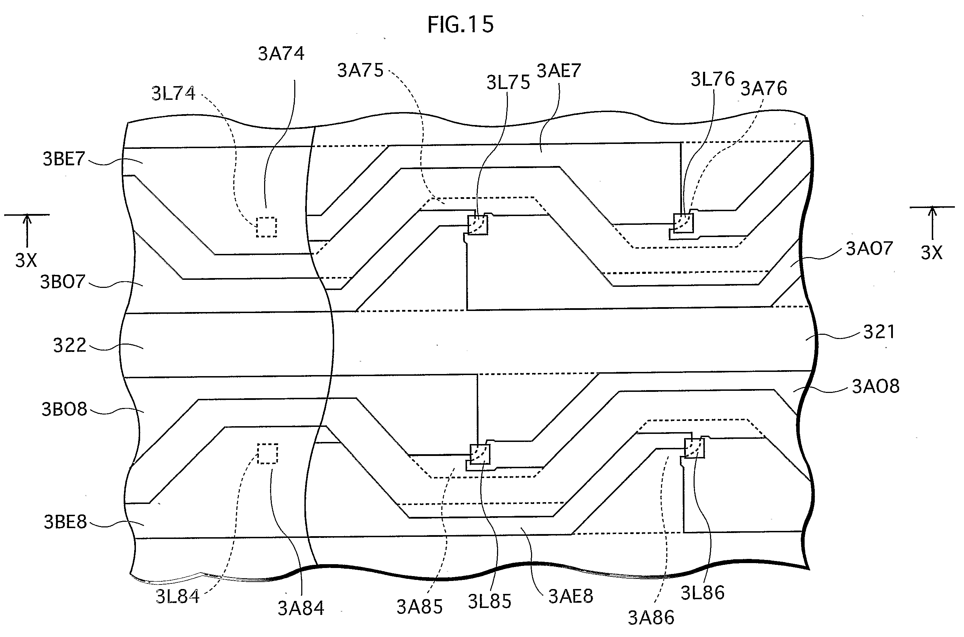

Fig. 15 is an enlarged detail of the portion B shown in Fig. 13, where part of the upper insulation layer 321 has been removed to show the lower insulation layer 322. Fig. 16 is a sectional view taken substantially along line 3X-3X of Fig. 15, viewed from a direction indicated by the arrows.

In Embodiment 3, the LED bare chips mounted at positions 3D11 to 3D88 are denoted by 3Lnm ("n" indicating an ordinal number of the row, and "m" an ordinal number of the column, "n" and "m" each being an integer ranging from "1" to "8") for differentiation from those in Embodiments 1 and 2.

As shown in Figs. 15 and 16, the lower insulation layer 322 contains heat conductive members 3Anm ("n" indicating an ordinal number of the row, and "m" an ordinal number of the column, "n" and "m" each being an integer ranging from "1" to "8") below (that is, on the rear side of) the LED bare chips at positions 3D11 to 3D88. The heat conductive members 3Anm constitute part of the wiring pattern 3PB and transmit heat, which is generated as the LED bare chips 3Lnm emit light, to the metal base 324 under the lower insulation layer 322.

With the above-described construction in which the lower insulation layer 322 has the heat conductive members 3Anm (wiring pattern 3PB) in the front surface thereof at positions corresponding to the mounting positions 3Dnm of the LED bare chips 3Lnm, heat, which is generated as the LED bare chips 3Lnm emit light, is transmitted to the metal base 324 via the heat conductive members 3Anm and released from the metal base 324. This prevents the LED bare chips 3Lnm from decreasing in the luminous efficiency or life.

Furthermore, the metal base wiring board 310 includes a multi-layer insulation substrate composed of the upper and lower insulation layers 321 and 322. This construction enables the LED bare chips 3Lnm to be mounted with high density on the insulation substrate by forming the wiring pattern on the two insulation layers, making full use of the multi-layer structure. This cannot be achieved by a single-layer insulation layer since it does not have enough area to cover all the desired wiring pattern observing the wiring pattern rules.

In the present case, the LED bare chips 3Lnm embedded in the front surface and the metal base 324 are relatively separated from each other. However, since the lower insulation layer 322 between the LED bare chips 3Lnm and the metal base 324 has the heat conductive members 3Anm, heat generated as the LED bare chips 3Lnm emit light is transmitted to the metal base 324 via the heat conductive members 3Anm and is released from the metal base 324.

### 2. Embodiment of LED Light Source

An embodiment of the metal base wiring board 310 will be described.

The upper and lower insulation layers 321 and 322 constituting the insulation substrate 320 are approximately 0.1 mm thick. The wiring pattern 3PA is approximately 9 *µ*m thick since the wiring pattern 3PA is expected to have narrow gaps. On the other hand, the wiring pattern 3PB is made of a normal copper foil that is approximately 35 µm thick. That is to say, the wiring pattern 3PB is thicker than the wiring pattern 3PA.

With the above-described construction, the wiring pattern 3PB, which is thicker than the wiring pattern 3PA, transmits more heat to the metal base 324.

It is preferable that the heat conductive members 3Anm are no smaller than one fourth (1/4) the insulation layer 321 or 322 in thickness. This is because otherwise, the amount of heat transmitted to the metal base 324 is small, thus providing a low heat dissipation.

The metal base 324 and LED bare chips 3Lnm, and the mounting positions of the LED bare chips in Embodiment 3 are the same as those in Embodiment 1.

### 3. Metal Base Wiring Board Manufacturing Process

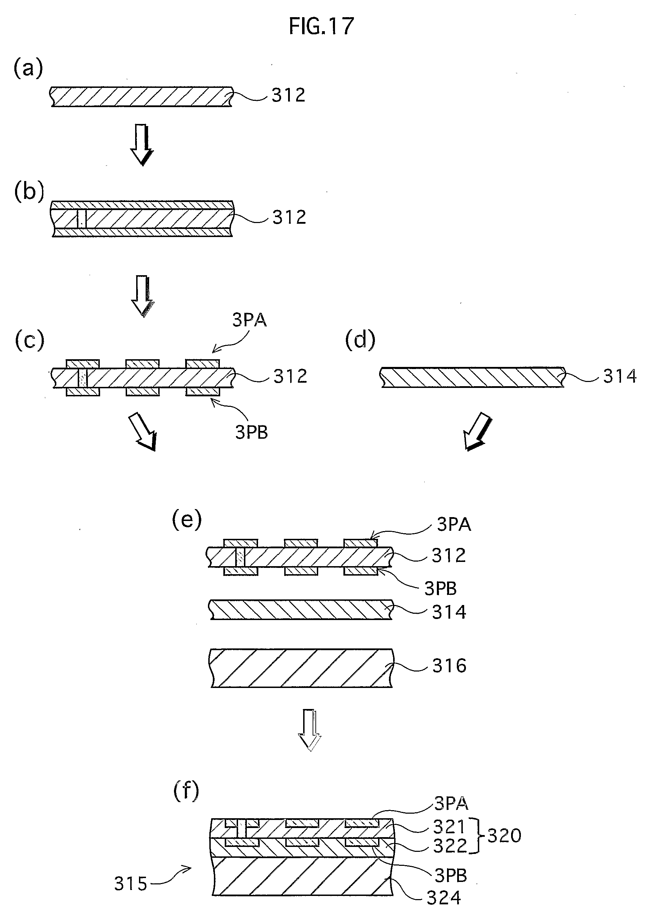

Fig. 17 illustrates the process of manufacturing the metal base wiring board.

How the metal base wiring board 315 is manufactured will be described briefly with reference to Fig. 17.

First, the upper insulation layer 321 production process will be described.

### <Step (a) >

An insulation plate 312 that has not been cured fully is prepared for the upper insulation layer 321. Through holes for via holes are then opened in the insulation plate 312 by stamping or the like, at predetermined positions. The through holes for via holes are then filled with a conductive material. <Step (b) >

A copper foil as a material of the wiring patterns 3PA and 3PB is attached to both surfaces of the insulation plate 312.

### <Step (c).>

Unnecessary portions of the copper foil are removed by etching, leaving the portions constituting the wiring patterns 3PA and 3PB on both surfaces.

In this way, the wiring pattern 3PA is formed on the front surface of the insulation plate 312, and the wiring pattern 3PB is formed on the rear surface of the insulation plate 312.

### <Step (d)>

An insulation plate 314 that has not been cured fully is prepared for the lower insulation layer 322.

### <Step (e)>

The insulation plate 314 is placed on a metal plate 316 for the metal base 324, and the insulation plate 312 is placed on the insulation plate 314 so that the wiring pattern 3PA formed in the front surface thereof is placed at the very top of the stack.

### <Step (f)>

The plates and the metal base put together as specified above are then attached together by application of pressure and heat. This completes the metal base wiring board 315 composed of the upper and lower insulation layers 321 and 322 and the metal base 324.

The LED bare chips 3Lnm are then mounted by flip-chip mounting onto the metal base wiring board 315 at the mounting positions. 3Dnm to complete the LED light source. In the present embodiment, as in the previous embodiments, semicured insulation plates 312 and 314 are cured, and the cured insulation plates 312 and 314 are used as insulation layers 321 and 322.

With the above-described process in which the wiring patterns 3PA and 3PB are formed by etching, it is possible to form the heat conductive members 3Anm with ease since the heat conductive members 3Anm, which should be positioned in correspondence with the mounting positions 3Dnm, can be formed as part of the wiring pattern 3PB.

Also, in the above-described process, pressure and heat are applied to the semicured insulation plate 312 on which the wiring patterns 3PA and 3PB have been formed, respectively. This causes the wiring pattern 3PA to be embedded in the front surface of the insulation plate 312, so that the front surface of the upper insulation layer 321 is substantially even.

More specifically, since the insulation plate 312 is made of a composite material composed of resin and inorganic fillers, the insulation plate 312 is softened by application of heat, causing the wiring pattern 3PA to be embedded in the front surface of the insulation plate 312. This enables the front surface of the upper insulation layer 321 to be substantially even.

With the above-stated process, asperities of the front surface of the insulation substrate are removed, allowing the LED bare chips 3Lnm to be mounted more easily. This enables all the light emitting layers of the mounted LED bare chips 3Lnm to be oriented towards substantially a same direction.

Further, as shown in Fig. 14, although the wiring pattern 3PB is formed in approximately the entire area of the front surface of the lower insulation layer 322, the odd-column chip connecting unit 3BOn and the even-column chip connecting unit 3BEn are separated from each other. This means that the areas except for the wiring pattern 3PB of the upper (front) surface of the lower insulation layer 322 are directly attached to the rear surface of the upper insulation layer 321. This enables the two layers to be attached together tightly. As a result, even if the area of the wiring pattern 3PB is increased to improve the heat dissipation, the upper and lower insulation layers 321 and 322 can be attached together tightly.

### Embodiment 4

Embodiment 4 of the present invention includes heat conductive members as separate entities from the wiring patterns, while in Embodiment 3, the heat conductive members 3Anm constitute part of the wiring pattern 3PB formed in the lower insulation layer 322. It should be noted here that in Embodiment 4, the reference signs used in Embodiment 3 are used by changing the first letter from "3" to "4".

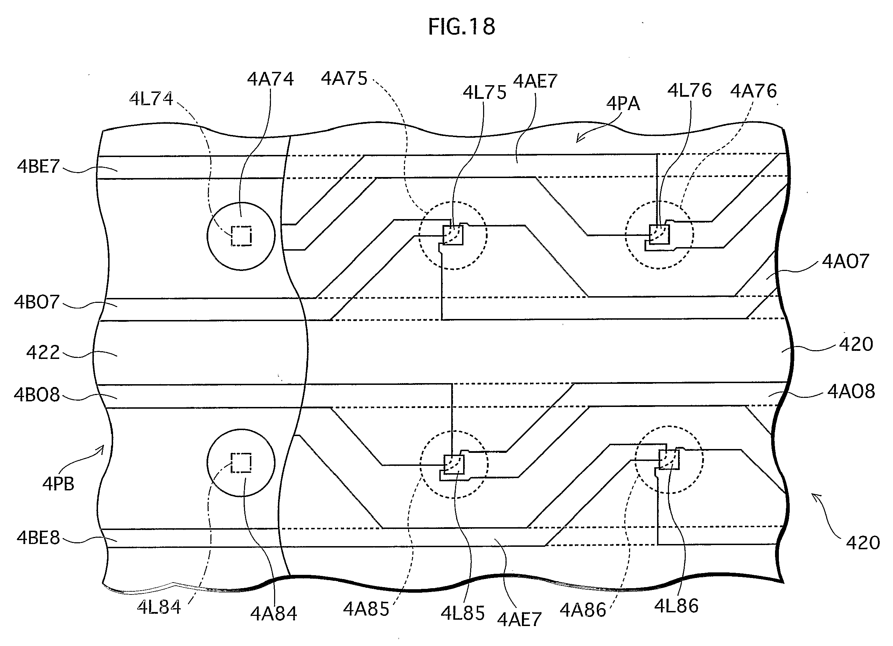

Fig. 18 is an enlarged top plan view of the metal base wiring board in Embodiment 4, where part of the upper insulation layer has been removed to show the lower insulation layer. In the following description, Fig. 18 is referred to.

As is the case with Embodiment 3, LED bare chips 4Lnm are mounted on the front surface of the upper insulation layer 421 ("n" indicating an ordinal number of the row, and "m" an ordinal number of the column, "n" and "m" each being an integer ranging from "1" to "8") to be connected to the wiring pattern 4PA (which includes 4AE7, 4AE8, 4AO7 and 4AO8 shown in Fig. 18), by flip-chip mounting. The following explanation refers to LED bare chips 4L74-4L76 and 4L84-4L86 shown in Fig. 18 for convenience's sake.

Also, the wiring pattern 4PB (which includes 4BE7, 4BE8, 4BO7 and 4BO8 shown in Fig. 18) is formed in the lower insulation layer422. Furthermore, heat conductive members 4Anm (4A74-4A76 and 4A84-4A86) shaped like circle are formed in the lower insulation layer 422 at positions corresponding to the positions of the LED bare chips 4Lnm (4L74-4L76 and 4L84-4L86). The heat conductive members 4Anm are provided, as is the case with the heat conductive members 3Anm in Embodiment 3, to transmit heat that is generated as the LED bare chips 4Lnm emit light, to the metal base 424 under the lower insulation layer 422. As a result, the heat conductive members 4Anm are made of a material that has a higher heat conductivity than the materials of the upper and lower insulation layers. More specifically, the upper and lower insulation layers 421 and 422 are made of the composite material (containing resin as the principal ingredient) that has been explained in Embodiment 3, and the heat conductive members 4Anm are made of copper, which is also the material of the wiring patterns 4PA and 4PB.

The heat conductive members 4Anm are formed together with the wiring pattern 4PB, in a similar manner to Embodiment 3. However, different from Embodiment 3, the heat conductive members 4Anm are formed as separate entities from the wiring pattern 4PB. The wiring pattern 4PB is used to supply the LED bare chips 4Lnm with electric current, enabling the LED bare chips 4Lnm to emit light. Accordingly, the wiring pattern 4PB and the heat conductive members 4Anm are different from each other in function.

As is the case with Embodiment 3, Embodiment 4 discloses a metal base wiring board that has heat conductive members 4Anm at positions corresponding to the mounting positions of the LED bare chips 4Lnm. Accordingly, with this construction, heat, which is generated as the LED bare chips 4Lnm emit light, is transmitted to the metal base 424 via the heat conductive members 4Anm and released from the metal base 424.

Also, since the heat conductive members 4Anm are formed as separate entities from the wiring pattern 4PB, the area in which the upper and lower insulation layers 421 and 422 are directly attached to each other in Embodiment 4 is larger than that in Embodiment 3. As a result, Embodiment 4 can attach the upper and lower insulation layers 421 and 422 to each other with a higher strength than Embodiment 3.

In Embodiments 3 and 4, the heat conductive members 3Anm and 4Anm are both circular in a plane view. However, they may be formed in other shapes such as polygon or oval. It is preferable that the heat conductive members 3Anm and 4Anm are respectively larger than the LED bare chips 3Lnm and 4Lnm in a plane view. In Embodiments 3 and 4, the diameter of the heat conductive members 3Anm and 4Anm is defined as 500 µm, respectively.

In Embodiment 4, the heat conductive members 4Anm are provided in correspondence with the LED bare chips 4Lnm on a one-to-one basis. However, each heat conductive member may be provided in correspondence with two LED bare chips 4Lnm. Alternatively, each heat conductive member may be shaped like a belt extending in the row direction to be provided in correspondence with a plurality of LED bare chips 4Lnm (for example, four odd-numbered or even-numbered LED bare chips).

### 4. Supplements and Variations

### <1. Insulation Substrate>

In Embodiment 4, the insulation substrate 420 is composed of two layers: upper and lower insulation layers 421 and 422. However, the number of the layers composing the insulation substrate is not limited to two. The following describes a few examples with different insulation layers in number.

### A. Insulation Substrate Having Single Layer (Variation 6)

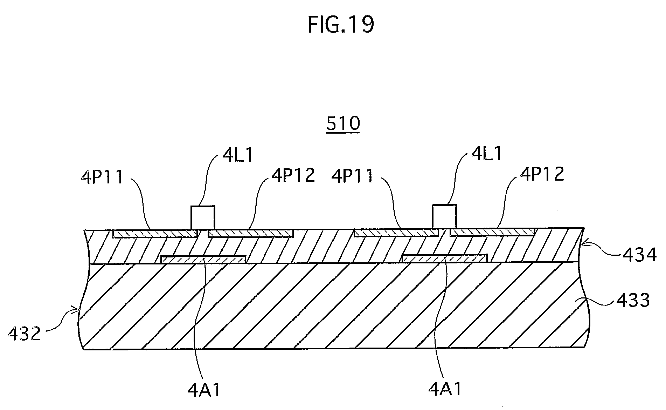

Fig. 19 is a sectional view of an LED light source having a single insulation layer made of a composite material.

As shown in Fig. 19, the metal base wiring board 432 is composed of: the insulation substrate 434 composed of a single layer; and the metal base 433 attached to the rear surface of the insulation substrate 434. The LED bare chips 4L1 is mounted on the front surface of the insulation substrate 434 by flip-chip mounting so as to be connected to the wiring patterns 4P11 and 4P12.

It should be noted here that this example in which a metal base wiring board having a single insulation layer made of a composite material is referred to as Variation 6.

On the rear surface of the insulation substrate 434, heat conductive members 4A1 are formed at positions corresponding to the mounting positions of the LED bare chips 4L1. In the present example, no wiring pattern is formed on the rear surface of the insulation substrate 434. However, a wiring pattern may be formed on the rear surface of the insulation substrate. In that case, it is necessary to provide an insulation layer between the wiring pattern and the metal base, or to insulate the metal base by, for example, alumite treatment.

The single-layer construction of the insulation substrate 434 provides superior heat dissipation, which is further enhanced by the heat conductive members 4A1 formed in the rear surface of the insulation substrate.

In this example, the heat conductive members 4A1 are formed in the rear surface of the insulation substrate 434. Here, it is possible, using a composite material for the insulation substrate 434, to cause the heat conductive members 4A1 to be embedded in the rear surface of the insulation substrate so that the rear surface of the insulation substrate 434 is substantially even.

With the above-described construction, the heat conductive members 4A1 are closer to the LED bare chips 4L1, and are in contact with the metal base 433. This further improves the heat dissipation.

### B. Insulation Substrate Having Three or More Layers

The present invention can also be applicable to a metal base wiring board using an insulation substrate composed of three or more layers. An example of such is as follows.

There are cases where LED bare chips emit three colors of light: red, blue and green, and wiring patterns of the colors are formed in three or four layers in an insulation substrate. In such a case, heat conductive members may be formed for each layer, or every two or more layers, in correspondence with the LED bare chips mounted in the front surface of the insulation substrate.

From the viewpoint of obtaining superior heat dissipation, it is most preferable that heat conductive members are formed in each layer. However, compared with the case where no heat conductive member is formed, forming heat conductive members even in one layer improves heat dissipation more or less.

### <2. LED bare Chips>

In Embodiment 4 and Variation 6, rear surface electrode type LED bare chips, in which electrodes are provided in the rear surface of the chips, are used. However, not limited to this, other types of LED bare chips may be used. As has been explained in "4. Supplements and Variations" in Embodiment 1, the double surface electrode type and the front surface electrode type may be used as well, for example. Here, the two cases will be explained as Variations 7 and 8, respectively.

### A. Mounting Double Surface Electrode Type (Variation 7)

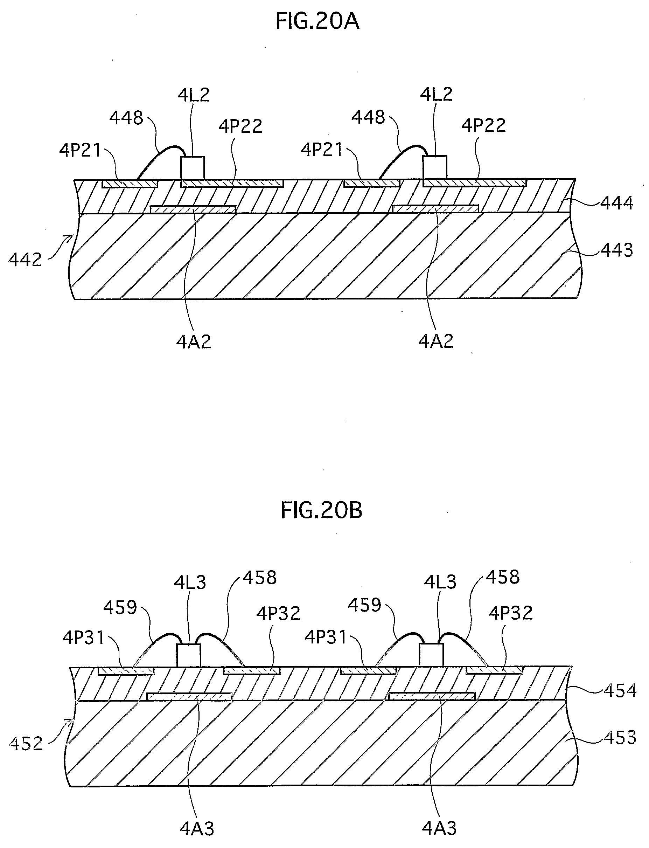

Fig. 20A is an enlarged cross-sectional view showing the connection of electrodes in the front surface of the double surface electrode type LED bare chips to the wiring pattern formed in the insulation substrate.

As shown in Fig. 20A, a metal base wiring board 442 has a metal base 443 and an insulation substrate 444 attached to the front surface of the metal base 443. The insulation substrate 444 has a single layer structure as is the case with Variation 6.

In the front surface of the insulation substrate 444, wiring patterns 4P21 and 4P22 corresponding to the wiring patterns 4P11 and 4P12 are formed. Also, in the rear surface of the insulation substrate 444, heat conductive members 4A2 are formed at positions corresponding to the mounting positions of the LED bare chips 4L2.

The LED bare chips 4L2 are double surface electrode type, and electrodes in the rear surface thereof are connected to the wiring pattern 4P22 via silver paste for die bonding. Electrodes in the front surface of LED bare chips 4L2 are connected to the wiring pattern 4P21 via wires 448.

In this way, the present invention is applicable to double surface electrode type LED bare chips. With this construction also, heat, which is generated as the LED bare chips 4L2 emit light, is transmitted to the metal base 443 via the heat conductive members 4A2, which are formed on the rear side of the LED bare chips 4L2, and released from the metal base 443.

### B. Mounting Front Surface Electrode Type (Variation 8)

Fig. 20B is an enlarged cross-sectional view showing the connection of electrodes in the front surface of the front surface electrode type LED bare chips to the wiring pattern formed in the insulation substrate.

As shown in Fig. 20B, a metal base wiring board 452 has a metal base 453 and an insulation substrate 454 having a single layer. In the front surface of the insulation substrate 454, wiring patterns 4P31 and 4P32 are formed. Also, in the rear surface of the insulation substrate 454, heat conductive members 4A3 are formed.

The LED bare chips 4L3 are front surface electrode type, and one of electrodes in the front surface of LED bare chips 4L3 is connected to the wiring pattern 4P31 via a wire 459, and another electrode in the front surface of LED bare chips 4L3 is connected to the wiring pattern 4P32 via a wire 458.

### C. Others

Variations 7 and 8 are based on Variation 6. However, off course, the double surface electrode type and front surface electrode type LED bare chips can be applied to Embodiments 3 and 4. In this case, wire bonding or the like may be used, as explained in Variations 7 and 8.

### Other Variations

Up to now, Embodiments 1-4 and Variations 1-8 have been explained in terms of: a metal base wiring board for retaining light emitting elements; and an LED light source using the metal base wiring board of the present invention. However, not limited to these embodiments and variations, the present invention can have the following variations, for example.

### <1. Recesses in Embodiments 1 and 2>

In Embodiments 1 and 2 and Variations 1-5, the recesses are circular in a plane view. However, they may be formed in other shapes such as polygon (for example, rectangle or triangle), or oval. Furthermore, the recesses may be formed as a continuously extended groove so that a plurality of LED bare chips can be mounted therein.

The recesses in Embodiment 1 and Variations 1-4 pass through the upper insulation layer, revealing part of the front surface of the lower layer whose rear surface is attached to the metal base, that is to say, leaving one layer intact. However, two or more adjacent layers including the one whose rear surface is attached to the metal base may be left intact instead. For example, in the case where an insulation substrate composed of three insulation layers is used, recesses may be formed to leave two insulation layers on the side of the metal base intact. It should be noted here that from the viewpoint of obtaining superior heat dissipation, it is most preferable that only one insulation layer is left intact.

Also, when an insulation substrate has three ormore layers, the recesses may be formed in a shape of a staircase. More specifically, a portion of the recess passing through the top layer of the insulation substrate is wider than a portion of the recess passing through the middle layer. In this case, the portions passing through the top and middle layers may be different in shapes. Such a design increases the number of possible wiring patterns. For example, electrodes in the front surface of the LED bare chips may be connected to a wiring pattern formed in the middle or top layer by wire bonding.

Also, when an insulation substrate has a plurality of insulation layers, the recesses may be formed to pass through the insulation layers starting with the top insulation layer and stopping halfway through the lowest insulation layer that is attached to the metal base. For example, when the insulation substrate is composed of two layers, the recesses may be shaped in a staircase to reveal the front surface of the insulation layer that is attached to the metal base. With such a construction, electrodes of the LED bare chips may be connected to a wiring pattern formed in the front surface of the insulation layer that is attached to the metal base.

### <2. Heat Conductive Members>

In Embodiments 3 and 4, copper is used as the material of the heat conductive members. However, basically, any material that has a higher heat conductivity than the material of the insulation substrate may be used for the heat conductive members since such a material can transmit heat that is generated as the LED bare chips emit light to the metal base efficiently. However, when the heat conductivity in the actual use is taken into consideration, it is preferable that a metal (for example, aluminum, gold, or silver) is used as the material of the heat conductive members.

### <3. LED Light Source>

### (a) Other LED Light Sources (Variations 9 and 10)

The LED light source in each of the above-described embodiments and variations has a construction including a metal base wiring board and LED bare chips. However, not limited to this, the present invention is applicable to other LED light sources. For example, the LED bare chips may be covered with variable lenses, reflectors or the like. The following is a description of such variations.

It should be noted here that the examples in the following explanation are based on the metal base wiring board 15 and the LED bare chips Lnm of Embodiment 1, and the other components of Embodiment 1 will be used with the same reference signs.

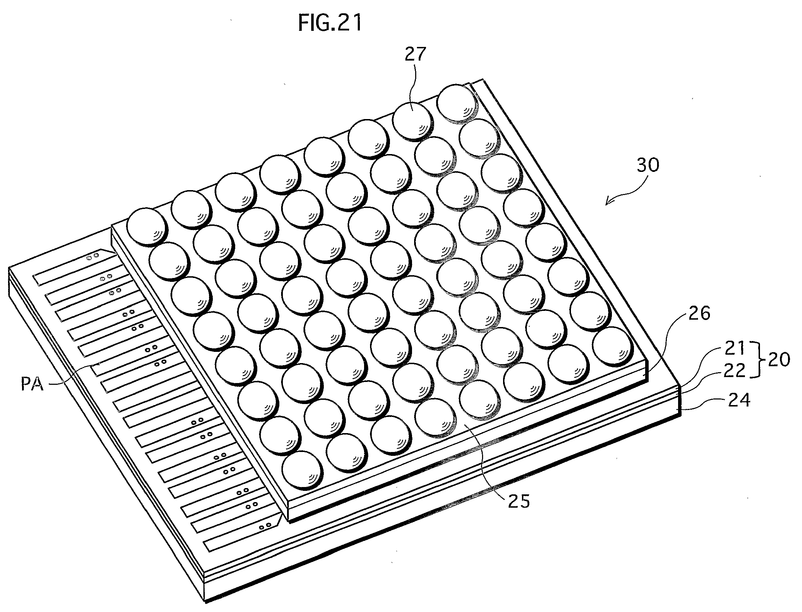

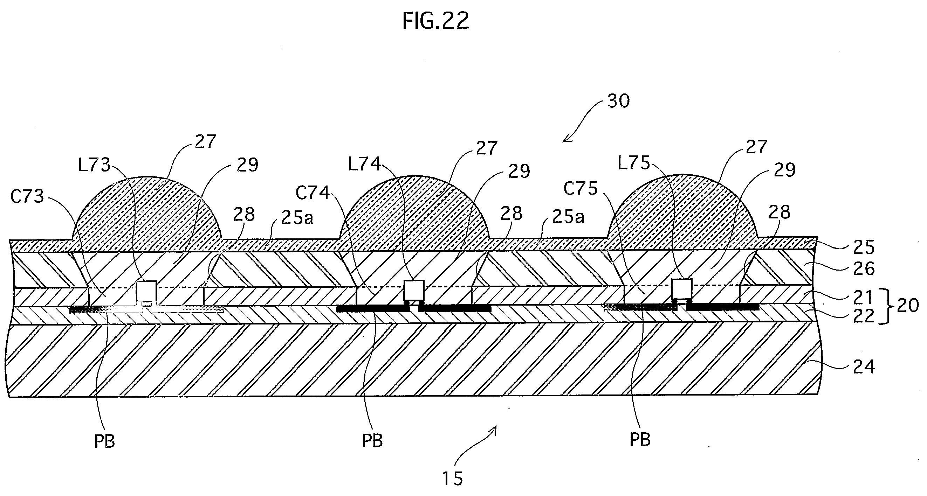

Fig. 21 is a perspective view showing an LED light source that includes a lens plate and a reflector. Fig. 22 is an enlarged cross-sectional view of LED bare chips mounted in the metal base wiring board 15. The example of LED light source shown in Figs. 21 and 22 is referred to as Variation 9.

As shown in Figs. 21 and 22, an LED light source 30 of Variation 9 includes a metal base wiring board 15 (having the same construction as that in Embodiment 1) in which LED bare chips are mounted, a reflector 26 attached to the front surface of the metal base wiring board 15, and a lens plate 25 attached to the front surface of the reflector 26.

As shown in Fig. 22, the reflector 26 has through holes 28 at positions corresponding to the positions of the LED bare chips Lnm (L73, L74 and L75 in Fig. 22), respectively. That is to say, the reflector 26 has 64 through holes 28 in a matrix with 8 rows and 8 columns. Each of the through holes 28 is shaped like a truncated cone, with the diameter on the side of the metal base wiring board 15 being smaller than that on the side of the lens plate. Also, a rim of each through hole 28 on the side of the upper insulation layer 21 substantially matches a rim of each corresponding recess Cnm on the side of the reflector 26.

The reflector 26 is achieved by, for example, a metal plate made of aluminum and is insulated by alumite treatment to secure insulation from the wiring pattern PA formed in the upper insulation layer 21. To reflect light emitted from the LED bare chips, the slant side wall of the through holes 28 may be treated with mirror finish or may be coated with a white reflection film. Each through hole 28 is filled with resin 29, which covers an LED bare chip Lnm.

As shown in Fig. 22, the lens plate 25 is deposited on the reflector 26 and includes lenses 27, which are hemispheres projecting upward (that is, in the opposite direction from the LED bare chips Lnm), at positions corresponding to the through holes 28 of the reflector 26. The lens plate 25 is made of, for example, transparent epoxy resin.

The LED bare chips Lnm are made of AlInGaN, as in Embodiment 1. With this construction, it is possible, by applying a phosphor to the lenses 27 or mixing the resin 29 with a phosphor, to cause the phosphor to emit visible light when excited by the light emitted from the LED bare chips Lnm. For example, it is possible to convert blue light to white light by using a YAG base phosphor.

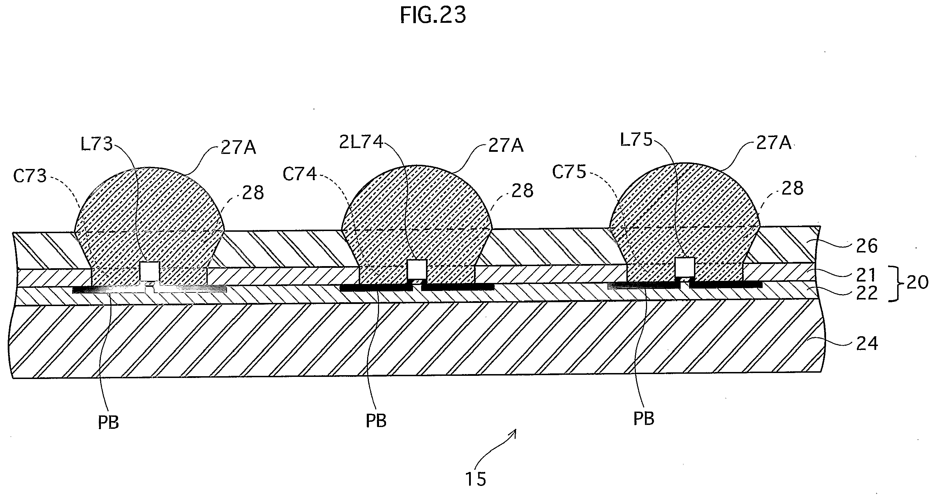

In Variation 9, the lens plate 25 is a plate with the lenses 27 formed at positions corresponding to the LED bare chips Lnm. However, the lens plate 25 may not be shaped like a plate or may not exist as far as lenses are formed therein at positions corresponding to the LED bare chips Lnm. For example, as shown in Fig. 23, independent lenses 27a may be formed at the through holes 28 of the reflector 26. The example of LED light source shown in Fig. 23 is referred to as Variation 10.

In Variation 10, the through holes 28 of the reflector 26 may be filled with resin used as the material of the lenses 27a, instead of the resin 29 used in Variation 9. Off course, it is possible to fill the through holes 28 with the resin 29 then form the lenses 27a thereon using resin for lens (epoxy resin in the case of the above example). With this construction, light emitted from the LED bare chips Lnm is emitted toward the front (upward in Fig. 23) passing through the lenses 27a.

In this section, the examples were provided using the metal base wiring board 15 and the LED bare chips Lnm. However, the lenses or a reflection plate may be attached to any metal base wiring board or LED bare chips disclosed in Embodiment 2, 3 or 4 or any of Variations 1-8.

### (b) Another LED Light Source (Variation 11)

Embodiments 1 and 2 disclose that LED bare chips are mounted on bottom faces of recesses formed in an insulation substrate. On the other hand, Embodiments 3 and 4 disclose that heat conductive members are deposited between a metal base and LED bare chips mounted in an insulation substrate. That is to say, the heat dissipation of the metal base wiring board is improved by means of either the recesses or the heat conductive members. However, the present invention includes a metal base wiring board having both the recesses and the heat conductive members, and a light source having the metal base wiring board.

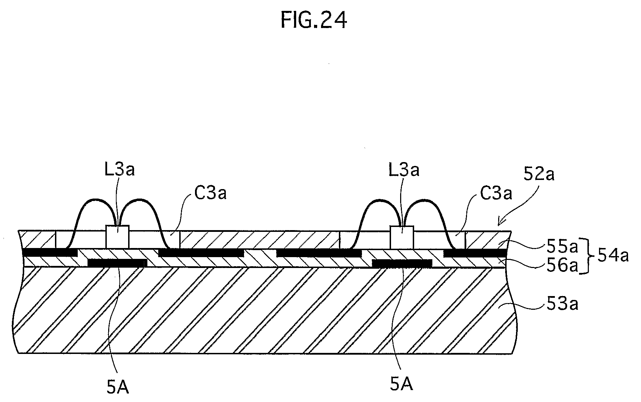

Fig. 24 shows an LED light source having recesses and heat conductive members, where the heat conductive members 5A are formed in the metal base wiring board 52a that has a similar construction to the metal base wiring board 52 of Embodiment 3 shown in Fig. 8A (hereinafter, this example is referred to as Variation 11).

A metal base wiring board 52a is composed of: an insulation substrate 54a composed of an upper insulation layer 55a and a lower insulation layer 56a; and a metal base 53a. The insulation substrate 54a has recesses C3a that pass through the upper insulation layer 55a and reach the lower insulation layer 56a.

The LED bare chips L3a are mounted on the bottom faces of the recesses C3a. Heat conductive members 5A are formed in the rear surface of the lower insulation layer 56a (a surface facing the metal base 53a) between the LED bare chips L3a and the metal base 53a.

Here, it is possible, using a composite material for the lower insulation layer 56a, to cause the heat conductive members 5A to be embedded in the rear surface of the lower insulation layer 56a so that the rear surface of the lower insulation layer 56a is substantially even. This construction decreases the distance between the LED bare chips and the heat conductive members 5A and provides excellent heat dissipation.

It should be noted here that Variation 11 is only one example of the construction having both the recesses and the heat conductive members, and heat conductive members may be formed in any insulation substrate disclosed in Embodiment 1 or 2 or Variation 1, 2 or 4. More specifically, heat conductive members may be formed in the rear surface of the lowest insulation layer facing the metal base, at positions corresponding to the mounting positions of the LED bare chips.

It should be noted here that the combination of recesses and heat conductive members may be applied to variable cases in which electrodes are positioned differently, electrodes are differently connected to the wiring patterns formed in the insulation substrate, or like.

### <4. Insulation Substrate>

### (a) Material of Insulation Layers

In the above-described embodiments and variations, a composite material is used as the material of the insulation layers. However, not limited to this, the insulation layers may be made of other materials such as a glass epoxy material.

When the LED bare chips are mounted in the front surface of a stack of insulation layers as in Embodiments 1, 3 and 4, it is preferable, from the viewpoint of securing heat conductivity between the LED bare chips and the metal base, that the insulation layers are as thin as possible since the thinner the layers are the higher the heat conductivity is. Taking this into consideration, it is preferable that the material of the insulation layers is selected from those that can vary the insulation layers in thickness.

### (b) Composite Material

In the above-described embodiments, the insulation layers are made of an alumina composite material. However, not limited to this, the insulation layers may be made of other composite materials. For example, the insulation layers may be made of any composite material containing inorganic fillers that are made of one or more materials selected from a group consisting of silica, magnesia, beryllia, boron nitride, aluminum nitride, silicon carbide, boron carbide, titanium carbide, silicon nitride, and diamond.

The ratio of the inorganic filler to the synthetic resin (thermosetting resin) in the composite material can be changed as desired. As a result, it is possible to form an insulation layer with excellent heat conductivity by using an inorganic filler having high heat conductivity and increasing its proportion in the composite material. It should be noted here that the alumina composite material has higher heat dissipation than the glass epoxy material.

It is also possible to change the elasticity and linear expansion coefficient of the composite material by changing the type of the inorganic filler and/or its proportion in the composite material. Accordingly, it is possible to form an insulation layer that is lower in elasticity than the glass epoxy material.

In the case where electrodes of the LED bare chips are first connected to the wiring patterns by wire bonding, and then are covered with resin, as in Variations 9 and 10, the temperature rises in the vicinity of the LED bare chips as they emit light, and the metal base expands. This causes the insulation layers to expand following the metal base. The expansion of the insulation layers causes a tensile stress between the wires and the wiring patterns of the insulation substrate to which the wires are connected.

In the above case, if the insulation layers are made of a composite material having a low elasticity, the insulation layers expand in the vicinity of the rear surface thereof following the metal base, but less expand in the vicinity of the front surface thereof. This is because the insulation layers having a low elasticity absorb the expansion of the metal base. As a result, a tensile stress between the wires and the wiring patterns in this case is smaller than in the case where the insulation layers are made of a glass epoxy material.

### <5. Metal Base>

In the above-described embodiments, the metal base is made using an aluminum plate. However, not limited to this, the metal base may be a plate made of, for example, iron, stainless steel, or copper. Furthermore, the metal base may have a fin structure in which the lower (rear) surface thereof (which is not attached to the insulation substrate) has a lot of recesses.

### <6. Metal Base Wiring Board>

The metal base wiring board may be manufactured by a different method from those of the above-described embodiments. For example, a wiring pattern formed on a transfer sheet may be transferred to a semicured resin substrate to form the metal base wiring board. This method also enables the metal base wiring board of Embodiment 1 to be manufactured (hereinafter, this example is referred to as Variation 12).

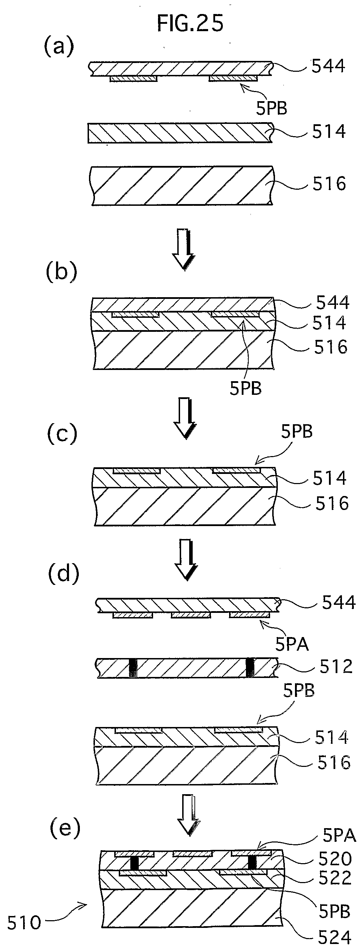

Fig. 25 illustrates the process of manufacturing the metal base wiring board. The manufacturing of the metal base wiring board will be described briefly with reference to Fig. 25. It shouldbe notedhere that the reference signs used in the following explanation include those that are made by adding letter "5" to corresponding reference signs of Embodiment 1.

Firstly, the lower insulation layer production process will be described.

### <Step (a)>

A copper foil that is, for example, 35 µm thick is attached to a transfer sheet 544 to cover the entire front surface thereof. Unnecessary portions of the copper foil are then removed by etching, leaving the portions constituting the wiring pattern 5PB. In this way, the wiring pattern 5PB is formed on a surface of the transfer sheet 544.

### <Step (b)>

The insulation plate 514 is placed on the metal plate 516 for the metal base. The transfer sheet 544 is then placed on the insulation plate 514 so that the surface having the wiring pattern 5PB faces the insulation plate 514. Pressure and heat are applied to the stack of plates. This causes the wiring pattern 5PB to be transferred to the insulation plate 514, so that the wiring pattern 5PB is embedded into the insulation plate 514. Also, the metal plate 516 is attached to the rear surface of the insulation plate 514.

### <Step (c)>

The transfer sheet 544 is removed. This completes the lower insulation layer 522 having the wiring pattern 5PB in the front surface thereof.

It should be noted here that the front surface of the lower insulation layer 522 is substantially even, with the wiring pattern 5PB embedded therein.

Secondly, the upper insulation layer production process will be described.

### <Step (d)>

In a similar manner to the lower insulation layer production process, a copper foil that is 9 µm thick is attached to a transfer sheet 544 to cover the entire front surface thereof. Unnecessary portions of the copper foil are then removed by etching, leaving the portions constituting the wiring pattern 5PA. In this way, the wiring pattern 5PA is formed on a surface of the transfer sheet 544.

Through holes are then opened in the insulation plate 512, which is prepared for the upper insulation layer, at positions where connections should be established with the wiring pattern 5PB. The through holes are then filled with conductive paste.

The insulation plate 512 is then placed on the stack of insulation plate 514 and metal plate 516. The transfer sheet 544 is then placed on the insulation plate 512 so that the surface having the wiring pattern 5PA faces the insulation plate 512.

### <Step (e)>

Pressure and heat are applied to the stack of plates. The transfer sheet 544 is then removed. This completes the upper insulation layer 520 having the wiring pattern 5PA in the front surface thereof, and completes a three-layer metal base wiring board 510 composed of the upper and lower insulation layers 520 and 522 and the metal base 524 that have been attached together.

It should be noted here that the front surface of the upper insulation layer 520 is substantially even, with the wiring pattern 5PA embedded therein.

A light emitting source is then completed after the LED bare chips are mounted on the metal base wiring board at predetermined positions, by flip-chip mounting.

With the above manufacturing method in which the wiring patterns are transferred from the transfer sheet 544 to semicured insulation plates for the insulation layers, the metal base wiring board having the wiring patterns 5PA and 5PB are formed with ease. Furthermore, since the wiring pattern 5PB also servers as a heat conductive member. There is no need to place or form heat conductive members independently. Accordingly, this method is easy and cost effective.

Also, with this method using a composite material composed of resin and inorganic fillers as the material of the insulation layers, the front surfaces of the insulation layers (and the front surface of the insulation substrate) can be made substantially even though the wiring patterns are formed therein. This makes it easy to mount the LED bare chips thereon and enables all the light emitting layers of the mounted LED bare chips to be oriented towards substantially a same direction.

### <7. Light Emitting Element>

### (a) LED Bare Chip

In Embodiments 1, 3 and 4 and Variation 6, LED bare chips are mounted by flip-chip mounting. However, not limited to this, LED bare chips may be mounted by other methods. For example, LED chips of the SMD (Surface Mounted Device) type may be used. When SMD-type LED chips are used, electrodes mounted on the side of the chips are connected to the wiring patterns by soldering or the like.

In the above-described embodiments and variations, LED bare chips are mounted in a matrix with 8 rows and 8 columns. However, the form and number of LED bare chips are not limited to this.

### (b) Color of Emitted Light

In the above described embodiments and variations, LED bare chips are used as light emitting elements. The LED bare chips may be arranged to emit lights of the same color or emit lights of different colors. For example, a plurality of LED bare chips may be arranged to emit any of red, blue or green light. Also, LED bare chips may be sets of three LED bare chips that respectively emit red, blue and green lights so that each set of three LED bare chips can emit lights of various colors with the adjustment of light output from each chip. In this case, however, currents applied to the LED bare chips of each set should be controlled to obtain a desired color output, a different wiring pattern for each color should be formed, and a lens or the like is required for mixing different colors that are emitted from the LED bare chips.

### (c) Light Emitting Element

In the above-described Embodiments and Variations, LED bare chips are used as light emitting elements to be mounted in the metal base wiring board. However, not limited to this, light emitting elements other than LED bare chips, for example, a laser diode may be used. However, when a laser diode is used, a lens for diffusing the light emitted from the laser diode may be required since the light emitted from the laser diode has a strong directional orientation.

Furthermore, what is called a sub-mount in which a light emitting element has been mounted on a substrate in advance may be used.

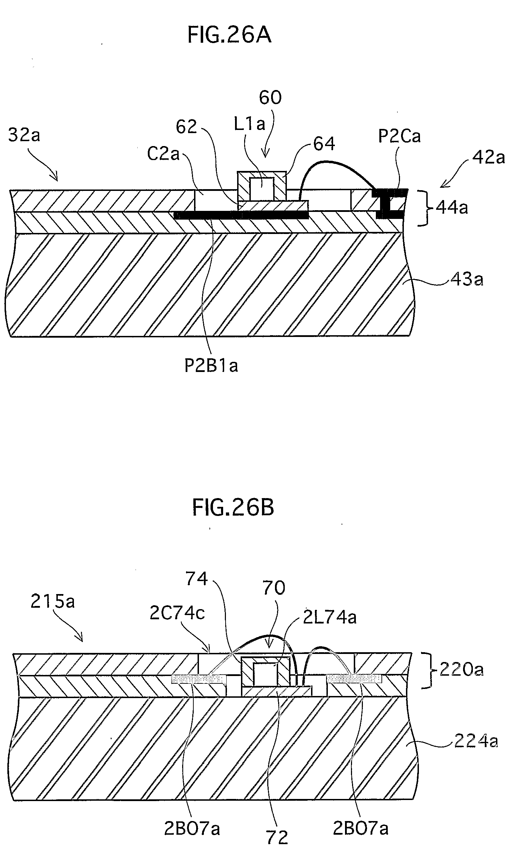

Figs. 26A and 26B show examples in which sub-mounts are used.

Fig. 26A shows an example in which LED bare chips L2 used in Variation 2 shown in Fig. 7B have been replaced with sub-mounts (hereinafter, this example is referred to as Variation 13).

A metal base wiring board 42a includes: an insulation substrate 44a having a recess C2a in the front surface thereof; and a metal base 43a attached to the rear surface of the insulation substrate 44a. A wiring pattern P2B1a is exposed at the bottom face of the recess C2a. Also, a pad P2Ca is formed in the insulation substrate 44a in the vicinity of the recess C2a.

A sub-mount 60 includes: for example, a silicon substrate (hereinafter referred to as Si substrate) 62; an LED bare chip L1a mounted, as a light emitting element, on the front surface of the Si substrate 62; and resin 64 that covers the LED bare chipL11. Two electrodes of the LED bare chip L1a are electrically connected to first and second terminals that are formed at the rear and front surfaces of the Si substrate 62, respectively.

The sub-mount 60 is mounted in the metal base wiring board 42a by die bonding via, for example, silverpaste. The electrical connection between the sub-mount 60 and the metal base wiring board 42a is achieved by, for example, connecting the first terminal formed at the rear surface of the Si substrate 62 to the wiring pattern P2B1a formed at the bottom face of the recess C2a via the silver paste, and connecting the second terminal formed at the front surfaces of the Si substrate 62 to the pad P2Ca formed at the front surface of the insulation substrate 44a via a wire.

With the light emitting source having the above-described construction, heat is generated as the LED bare chip emits light. However, the above-described light emitting source provides excellent heat dissipation since the distance between the sub-mount 60 (light emitting element) and the metal base 43a is smaller than that of a light emitting source that does not have a recess.

The existence of the Si substrate 62 between the LED bare chip L1a and the insulation substrate 44a slightly reduces the heat dissipation when compared with the case where the LED bare chip is mounted directly by flip-chip mounting. However, since silicon has high heat conductivity, the above-described light emitting source provides excellent heat dissipation that is close to that of the case where the LED bare chip is mounted directly.

Whether the LED bare chip L1a of the sub-mount 60 normally emits light or not can be checked before the sub-mount 60 is mounted in the metal base wiring board 42a since the LED bare chip L11 is mounted on the Si substrate 62 in advance. This provides advantageous effects. For example, it is possible to raise yields of the light emitting source by mounting into the metal base wiring board 42a a sub-mount that has been checked for lighting.

Fig. 26B shows an example in which LED bare chip 2L74 used in Embodiment 2 shown in Fig. 10 has been replaced with a sub-mount (hereinafter, this example is referred to as Variation 14).

A metal base wiring board 215a has a recess 2C74c in the front surface thereof. The recess 2C74c passes through the insulation substrate 220a and reaches a metal base 224a. A sub-mount 70 is mounted on the bottom face of the recess 2C74c.

As is the case with Variation 13, the sub-mount 70 includes : a Si substrate 72; an LED bare chip 2L74a; and resin 74 that covers the LED bare chip 2L74a. An electrode of the LED bare chip is electrically connected to a terminal formed in the front surface of the Si substrate 72.

The sub-mount 70 is mounted on the bottom face of the recess 2C74c in the metal base wiring board 215a by die bonding via, for example, silver paste. Two terminals of the Si substrate 72 are connected to an electrode pattern 2BO7a formed in the insulation substrate 220a, via wires.

Variations 13 and 14 have sub-mounts as a substitute for the LED bare chips of Variation 2 and Embodiment 2, respectively. However, a light emitting source may have both LED bare chips and sub-mounts.

### <8. Lighting Apparatus>

In each embodiment, a light emitting source has been explained mainly. However, it is off course possible to use the light emitting source in a lighting apparatus by supplying the light emitting source with power via a terminal.

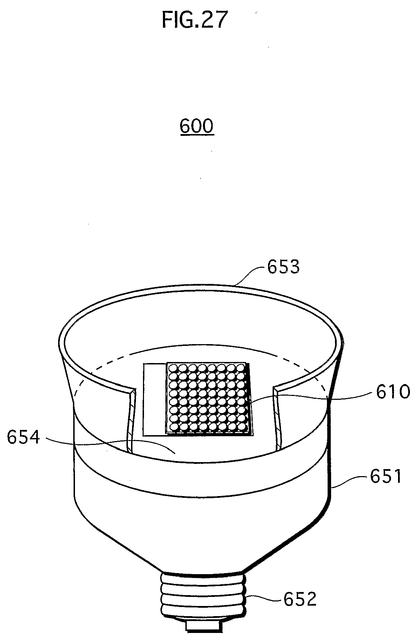

Fig. 27 shows an example of a lighting apparatus using the LED light source of Variation 9.

A lighting apparatus 600 has a case 651 that is composed of a base 652 and a reflection shade 653. An LED light source 610 is attached to the case 651. The base 652 conforms to a standard that is also used for normal incandescent electric lamps. The reflection shade 653 reflects the light, which is emitted from the LED light source 610, toward the front. The LED light source 610 has the same construction as the LED light source 30 of Variation 9.

The LED light source 610 is attached to an attaching unit 654 provided in the case 651, on the opposite side thereof from the base 652. The case 651 includes a power supply circuit that supplies the LED bare chips with power via a power supply terminal. The power supply circuit includes, for example, a rectifier circuit for rectifying alternating power supplied from a commercial power source to direct power; and a voltage adj ustment circuit for adjusting the voltage of the direct power output from the rectifier circuit.

### <9. Display Apparatus>

The metal base wiring board described above in each embodiment in which LED bare chips are mounted in a matrix with 8 rows and 8 columns may be used for a display apparatus. In this case, however, the wiring pattern needs to be changed to enable the light emission of each LED bare chip to be controlled independently. Also, for example, a known light emission control circuit is required to display characters, signs or the like by controlling the light emission of each LED bare chip.

The above-described display apparatus has LED bare chips mounted in a matrix with 8 rows and 8 columns. However, the form and number of LED bare chips are not limited to this. Also, the metal base wiring board having a plurality of ("64" in the above-described embodiments) LED bare chips, which is explained in the embodiments, may be used as one light emitting source for a display apparatus. It should be noted here that if, in the above-described LED light source, each of the LED bare chips arranged in a matrix with 8 rows and 8 columns can independently emit light, the LED light source can be used to display, for example, numerals. Such an LED light source can be used for a display apparatus.

In the above description, the lighting apparatus is explained using the LED light source of Variation 9. However, the lighting apparatus or display apparatus may use the other light emitting sources explained in the other embodiments or variations.

### Supplements

The drawings referred to in the above description have been illustrated to help one grasp the present invention conceptually. As a result, the illustrations may be different from the actual entities in shape, measurement, thickness of the wiring patterns, and so on.

### Industrial Applicability

The metal base wiring board, light emitting 'source, lighting apparatus, and display apparatus of the present invention provide improved heat dissipation.

## Claims

1. A metal base wiring board (15) for retaining a plurality of light emitting elements (Lnm, n=1-8, m=1-8), comprising:
an insulation substrate (20) having a plurality of recesses (Cnm, n=1-8, m=1-8) whose bottom faces are planned mounting position of the light emitting elements (Lnm, n=1-8, m=1-8), and including a wiring pattern (PA, PB) formed therein to interconnect the light emitting elements (Lnm, n=1-8, m=1-8) mounted in the recesses (Cnm, n=1-8, m=1-8); and
a metal base (24) attached to a rear surface of the insulation substrate (20), wherein
the insulation substrate (20) has a multi-layer structure composed of a plurality of insulation layers (21, 22), **characterized in that**
the recesses (Cnm, n=1-8, m=1-8) pass through insulation layers (21, 22) starting with a top layer (21) of the plurality of insulation layers (21, 22), leaving intact at least a bottom layer (22) that is attached to the metal base (24), and circumferential side surfaces of the recesses (Cnm, n=1-8, m=1-8) are substantially perpendicular to the bottom faces,
the wiring pattern (PA, PB) includes:
a first wiring pattern (PB) that is formed in the front surface of the insulation layer (22) that is partially the bottom faces of the recesses (Cnm, n=1-8, m=1-8), wherein part of the first wiring pattern (PB) is exposed in the recesses (Cnm, n=1-8, m=1-8), the first wiring pattern (PB) has a plurality of rows of light emitting element connecting unit (BEn, BOn, n=1-8), and part of the rows of light emitting element connecting unit (BEn, BOn, n=1-8) belonging to the part of the first wiring pattern (PB) exposed in the recesses (Cnm, n=1-8, m=1-8) is to be connected to two electrodes provided in the light emitting elements (Lnm, n=1-8, m=1-8) so that the light emitting elements (Lnm, n=1-8, m=1-8) are connected in series; and
a second wiring pattern (PA) that is formed in a front surface of an insulation layer (21) that exists on a front side of the insulation layer (22) in which the first wiring pattern (PB) is formed, and that has a pattern connecting unit (ARn, ALn, n=1-8) for connecting the plurality of rows of light emitting element connecting unit (BEn, BOn, n=1-8) in series,
the first wiring pattern (PB) and the second wiring pattern (PA) are electrically connected to each other via a via hole (V), and
a heat conductive member (3Anm, n=1-8, m=1-8), which has higher heat conductivity than the insulation substrate (20), is embedded in the insulation substrate (20) between the bottom faces and the metal base (24).

2. The metal base wiring board (15) of claim 1, wherein
the second wiring pattern is (PA) formed in a front surface of an insulation layer (21) that exists on a front side of the insulation layer (22) that is partially the bottom faces of the recesses (Cnm, n=1-8, m=1-8).

3. The metal base wiring board (15) of claim 1, wherein
the recesses (Cnm, n=1-8, m=1-8) are formed at regular intervals.

4. The metal base wiring board (15) of claim 1, wherein
the recesses (Cnm, n=1-8, m=1-8) are circular in a plan view, and are ranging from 0,5 mm to 2.0 mm inclusive in diameter,

5. The metal base wiring board (15) of claim 1, wherein
the recesses (Cnm, n=1-8, m=1-8) become smaller in diameter on a layer-to-layer basis as the recesses (Cnm, n=1-8, m=1-8) are closer to the metal base (24).

6. The metal base wiring board (15) of claim 1, wherein
the insulation layers (21, 22) are made of a material containing resin and an inorganic filler.

7. The metal base wiring board (15) of claim 6, wherein
the inorganic filler is made of one or more materials selected from a group consisting of silica, alumina, magnesia, beryllia, boron nitride, aluminum nitride, silicon carbide, boron carbide, titanium carbide, silicon nitride, and diamond.

8. The metal base wiring board (15) of claim 6, wherein
the wiring pattern (PA, PB) is formed in each of the plurality of insulation layers (21, 22) by a pattern transfer method.

9. A light emitting source (10) comprising:
the metal base wiring board (15) defined in claim 1; and
light emitting elements (Lnm, n=1-8, m=1-8) having been mounted on bottom faces of the recesses (Cnm, n=1-8, m=1-8) in the metal base wiring board (15).

10. The light emitting source (10) of claim 9, wherein
each of the light emitting elements (Lnm, n=1-8, m=1-8) has a pair of electrodes in a rear surface thereof, and is mounted on a bottom face of a recess (Cnm, n=1-8, m=1-8) so that the electrodes are connected to the first wiring pattern (PB).

11. The light emitting source (10) of claim 10, wherein
each of the light emitting elements (Lnm, n=1-8, m=1-8) is a sub-mount (60) that includes:
a substrate (62) having a terminal; and
a light emitting diode bare chip and/or a light emitting diode (L1a), each of which is mounted in a front surface of the substrate (62), and has an electrode in a rear surface thereof that is connected to the terminal of the substrate (62).

12. The light emitting source (10) of claim 9, wherein
each of the light emitting elements (Lnm, n=1-8, m=1-8) has an electrode in each of front and rear surfaces thereof, the electrode in the front surface being connected to the second wiring pattern (PA), and the electrode in the rear surface being connected to the first wiring pattern (PB).

13. The light emitting source (10) of claim 12, wherein
each of the light emitting elements (Lnm, n=1-8, m=1-8) is a sub-mount (60) that includes:
a substrate (62) having a terminal; and
a light emitting diode bare chip and/or a light emitting diode (L1a), each of which is mounted in a front surface of the substrate (62), and has two electrodes that are respectively connected to terminals formed in front and rear surfaces of the substrate (62).

14. The light emitting source (10) of claim 9, wherein
each of the light emitting elements (Lnm, n=1-8, m=1-8) has a pair of electrodes in a front surface thereof, the electrodes being connected to the wiring pattern (PA, PB) by wire bonding.

15. The light emitting source (10) of claim 14, wherein
each of the light emitting elements (Lnm, n=1-8, m=1-8) is a sub-mount (60) that includes:
a substrate (62) having a terminal; and
a light emitting diode bare chip and/or a light emitting diode (L1a), each of which is mounted in a front surface of the substrate (62), and has a pair of electrodes in a front surface thereof that are connected to the terminal of the substrate (62).

16. A lighting apparatus (600) using the light emitting source (10) defined in claim 9.

17. A display apparatus using the light emitting source (10) defined in claim 9.

## Patentansprüche

1. Metallbasis-Verdrahtungsplatte (15) zum Halten einer Vielzahl von lichtemittierenden Elementen (Lnm, n=1-8, m=1-8), umfassend:
ein Isolationssubstrat (20) mit einer Vielzahl von Ausnehmungen (Cnm, n=1-8, m=1-8), deren Bodenflächen vorgesehene Montageposition der lichtemittierenden Elemente (Lnm, n=1-8, m=1-8) sind, und welches ein Verdrahtungsmuster (PA, PB) umfasst, das darin ausgebildet ist, um die lichtemittierenden Elemente (Lnm, n=1-8, m=1-8), die in den Ausnehmungen (Cnm, n=1-8, m=1-8) montiert sind, miteinander zu verbinden; und
eine Metallbasis (24), die an einer hinteren Fläche des Isolationssubstrats (20) angebracht ist, wobei
das Isolationssubstrat (20) eine mehrlagige Struktur aufweist, die aus einer Vielzahl von Isolationsschichten (21, 22) zusammengesetzt ist, **dadurch gekennzeichnet, dass**
die Ausnehmungen (Cnm, n=1-8, m=1-8) sich durch Isolationsschichten (21, 22) hindurch erstrecken, ausgehend von einer Deckschicht (21) der Vielzahl Isolationsschichten (21, 22), wenigstens eine Bodenschicht (22) intakt lassend, die auf der Metallbasis (24) angebracht ist, und Umfangseitenflächen der Ausnehmungen (Cnm, n=1-8, m=1-8) im Wesentlichen senkrecht zu den Bodenflächen sind,
das Verdrahtungsmuster (PA, PB) umfasst:
ein erstes Verdrahtungsmuster (PB), das in der Vorderfläche der Isolationsschicht (22) ausgebildet ist, die teilweise die Bodenflächen der Ausnehmungen (Cnm, n=1-8, m=1-8) bildet, wobei ein Teil des ersten Verdrahtungsmusters (PB) in den Ausnehmungen (Cnm, n=1-8, m=1-8) freigelegt ist, wobei das erste Verdrahtungsmuster (PB) eine Vielzahl von Reihen einer lichtemittierenden-Elementen-Verbindungseinheit (BEn, BOn, n=1-8) aufweist, und wobei ein Teil der Reihen der lichtemittierenden-Elemente-Verbindungseinheit (BEn, BOn, n=1-8), der dem Teil des ersten Verdrahtungsmusters (PB) zugehörend ist, der in den Ausnehmungen (Cnm, n=1-8, m=1-8) freigelegt ist, mit zwei Elektroden, die in den lichtemittierenden Elementen (Lnm, n=1-8, m=1-8) bereitgestellt sind, zu verbinden ist, so dass die lichtemittierenden Elemente (Lnm, n=1-8, m=1-8) in Reihenschaltung verbunden sind; und
ein zweites Verdrahtungsmuster (PA), das in einer Vorderfläche einer Isolationsschicht (21) ausgebildet ist, die auf einer Vorderseite derjenigen Isolationsschicht (22) vorhanden ist, in der das erste Verdrahtungsmuster (PB) ausgebildet ist, und das eine Musterverbindungseinheit (ARn, ALn, n=1-8) aufweist, zum Verbinden der Vielzahl der Reihen der lichtemittierenden-Elemente-Verbindungseinheit (BEn, BOn, n=1-8) in Reihenschaltung, wobei
das erste Verdrahtungsmuster (PB) und das zweite Verdrahtungsmuster (PA) elektrisch miteinander über ein Durchgangsloch (V) verbunden sind, und
ein wärmeleitendendes Bauelement (3Anm, n=1-8, m=1-8), das höhere Wärmeleitfähigkeit aufweist als das Isolationssubstrat (20), in dem Isolationssubstrat (20) zwischen den Bodenflächen und der Metallbasis (24) eingebettet ist.

2. Metallbasis-Verdrahtungsplatte (15) nach Anspruch 1, wobei das zweite Verdrahtungsmuster (PA) in einer Vorderfläche einer Isolationsschicht (21) ausgebebildet ist, die auf einer Vorderseite der Isolationsschicht (22) vorhanden ist, die teilweise die Bodenflächen der Ausnehmungen (Cnm, n=1-8, m=1-8) bildet.

3. Metallbasis-Verdrahtungsplatte (15) nach Anspruch 1, wobei
die Ausnehmungen (Cnm, n=1-8, m=1-8) in regelmäßigen Abständen ausgebildet sind.

4. Metallbasis-Verdrahtungsplatte (15) nach Anspruch 1, wobei
die Ausnehmungen (Cnm, n=1-8, m=1-8) in einer Draufsicht kreisförmig sind und einen Durchmesser im Bereich von 0,5mm bis 2,0mm haben.

5. Metallbasis-Verdrahtungsplatte (15) nach Anspruch 1, wobei
die Ausnehmungen (Cnm, n=1-8, m=1-8) im Durchmesser von Schicht zu Schicht kleiner werden , je näher die Ausnehmungen (Cnm, n=1-8, m=1-8) der Metallbasis (24) sind.

6. Metallbasis-Verdrahtungsplatte (15) nach Anspruch 1, wobei die Isolationsschichten (21, 22) aus einem Material gefertigt sind, das Harz und einen anorganischen Füllstoff enthält.

7. Metallbasis-Verdrahtungsplatte (15) nach Anspruch 6, wobei der anorganische Füllstoff aus einem oder mehr Materialien ist, ausgewählt aus einer Gruppe bestehend aus Silica, Aluminiumoxid, Magnesia, Berylliumoxid, Bornitrid, Aluminiumnitrid, Siliziumcarbid, Borcarbid, Titancarbid, Siliziumnitrid und Diamant.

8. Metallbasis-Verdrahtungsplatte (15) nach Anspruch 6, wobei
das Verdrahtungsmuster (PA, PB) durch ein Musterübertragungsverfahren in jeder der Vielzahl der Isolationsschichten (21, 22) ausgebildet ist.

9. Lichtemittierende Quelle (10), bestehend aus:
der Metallbasis-Verdrahtungsplatte (15) nach Anspruch 1; und
lichtemittierenden Elementen (Lnm, n=1-8, m=1-8), die auf Bodenflächen der Ausnehmungen (Cnm, n=1-8, m=1-8) in der Metallbasis-Verdrahtungsplatte (15) montiert worden sind.

10. Lichtemittierende Quelle (10) nach Anspruch 9, wobei
jedes der lichtemittierenden Elemente (Lnm, n=1-8, m=1-8) ein Elektroden-Paar in seiner hinteren Fläche aufweist und auf einer Bodenfläche einer Ausnehmung (Cnm, n=1-8, m=1-8) montiert ist, so dass die Elektroden mit dem ersten Verdrahtungsmuster (PB) verbunden sind.

11. Lichtemittierende Quelle (10) nach Anspruch 10, wobei
jedes der lichtemittierenden Elemente (Lnm, n=1-8, m=1-8) eine Submount-Komponente (60) ist, die umfasst:
ein Substrat (62), das einen Anschluss aufweist; und
einen lichtemittierenden Dioden-Nacktchip und/oder eine lichtemittierende Diode (L1a), jeweils in einer vorderen Fläche des Substrates (62) montiert und eine Elektrode in einer hinteren Fläche davon aufweisend, die mit dem Anschluss des Substrats (62) verbunden ist.

12. Lichtemittierende Quelle (10) nach Anspruch 9, wobei
jedes der lichtemittierenden Elemente (Lnm, n=1-8, m=1-8) eine Elektrode in sowohl seiner vorderen als auch seiner hinteren Fläche aufweist, wobei die Elektrode in der vorderen Fläche mit dem zweiten Verdrahtungsmuster (PA) verbunden ist, und die Elektrode in der hinteren Fläche mit dem ersten Verdrahtungsmuster (PB) verbunden ist.

13. Lichtemittierende Quelle (10) nach Anspruch 12, wobei
jedes der lichtemittierenden Elemente (Lnm, n=1-8, m=1-8) eine Submount-Komponente (60) ist, die umfasst:
ein Substrat (62), das einen Anschluss aufweist, und
einen lichtemittierenden Dioden-Nacktchip und/oder eine lichtemittierende Diode (L1a), jeweils in einer vorderen Fläche des Substrates (62) montiert und zwei Elektroden aufweisend, die mit jeweiligen Anschlüssen verbunden sind, welche an vorderer und hinterer Fläche des Substrates (62) ausgebildet sind.

14. Lichtemittierende Quelle (10) nach Anspruch 9, wobei
jedes der lichtemittierenden Elemente (Lmn, n=1-8, m=1-8) ein Elektroden-Paar in seiner vorderen Fläche aufweist, wobei die Elektroden mit dem Verdrahtungsmuster (PA, PB) durch Drahtbonden verbunden sind.

15. Lichtemittierende Quelle (10) nach Anspruch 14, wobei
jedes der lichtemittierenden Elemente (Lnm, n=1-8, m=1-8) eine Submount-Komponente (60) ist, die umfasst:
ein Substrat (62), das einen Anschluss aufweist, und
einen lichtemittierenden Dioden-Nacktchip und/oder eine lichtemittierende Diode (L1a), jeweils in einer vorderen Fläche des Substrates (62) montiert und ein ElektrodenPaar in einer vorderen Fläche davon aufweisend, das mit dem Anschluss des Substrates (62) verbunden ist.

16. Beleuchtungsvorrichtung (600), welche die lichtemittierende Quelle (10) nach Anspruch 9 verwendet.

17. Anzeigevorrichtung, welche die lichtemittierende Quelle (10) nach Anspruch 9 verwendet.

## Revendications

1. Carte de câblage à base de métal (15) destinée à retenir une pluralité d'éléments émetteurs de lumière (Lnm, n=1-8, m=1-8), comprenant:
un substrat isolant (20) ayant une pluralité d'évidements (Cnm, n=1-8, m=1-8) dont les faces de fond sont de la position de montage prévue des d'éléments émetteurs de lumière (Lnm, n=1-8, m=1-8), et comprenant un motif de câblage (PA, PB) formé dans celui-ci afin d'interconnecter les éléments émetteurs de lumière (Lnm, n=1-8, m=1-8) montés dans lesdits évidements (Cnm, n=1-8, m=1-8); et
une base de métal (24) qui est fixée sur une surface arrière du substrat isolant (20), dans laquelle
ledit substrat isolant (20) présente une structure multicouche composée d'une pluralité de couches isolantes (21, 22), **caractérisée par le fait que**
les évidements (Cnm, n=1-8, m=1-8) passent à travers des couches isolantes (21, 22), à partir d'une couche supérieure (21) de la pluralité de couches isolantes (21, 22), en laissant intacte au moins une couche de fond (22) qui est fixée sur la base de métal (24), et que des surfaces latérales circonférentielles des évidements (Cnm, n=1-8, m=1-8) sont pour l'essentiel perpendiculaires aux faces de fond,
le motif de câblage (PA, PB) comprend:
un premier motif de câblage (PB) qui est formé dans la surface avant de la couche isolante (22) qui forme en partie les faces de fond des évidements (Cnm, n=1-8, m=1-8), une partie du premier motif de câblage (PB) étant dégagée dans les évidements (Cnm, n=1-8, m=1-8), le premier motif de câblage (PB) présentant une pluralité de rangées d'une unité de connexion d'éléments émetteurs de lumière (BEn, BOn, n=1-8), et une partie des rangées de l'unité de connexion d'éléments émetteurs de lumière (BEn, BOn, n=1-8) qui appartient à la partie du premier motif de câblage (PB) qui est dégagée dans les évidements (Cnm, n=1-8, m=1-8) étant à connecter à deux électrodes prévues dans les éléments émetteurs de lumière (Lnm, n=1-8, m=1-8) de sorte que les éléments émetteurs de lumière (Lnm, n=1-8, m=1-8) sont connectés en série; et
un deuxième motif de câblage (PA) lequel est formé dans une surface avant d'une couche isolante (21) qui est présente sur une face avant de la couche isolante (22) dans laquelle est formé le premier motif de câblage (PB), et lequel présente une unité de connexion de motif (ARn, ALn, n=1-8) pour connecter en série la pluralité des rangées de l'unité de connexion d'éléments émetteurs de lumière (BEn, BOn, n=1-8), dans lequel
ledit premier motif de câblage (PB) et ledit deuxième motif de câblage (PA) sont connectés électriquement entre eux par un trou de liaison (V), et
un composant conducteur de chaleur (3Anm, n=1-8, m=1-8) qui présente de la conductivité thermique supérieure à celle du substrat isolant (20) est enrobé dans le substrat isolant (20) entre les faces de fond et la base de métal (24).

2. Carte de câblage à base de métal (15) selon la revendication 1, dans laquelle
le deuxième motif de câblage (PA) est formé dans une surface avant d'une couche isolante (21) qui est présente sur une face avant de la couche isolante (22) qui forme en partie les faces de fond des évidements (Cnm, n=1-8, m=1-8).

3. Carte de câblage à base de métal (15) selon la revendication 1, dans laquelle les évidements (Cnm, n=1-8, m=1-8) sont formés à des intervalles réguliers.

4. Carte de câblage à base de métal (15) selon la revendication 1, dans laquelle
les évidements (Cnm, n=1-8, m=1-8) sont circulaires dans une vue en plan et présentent un diamètre compris entre 0,5 mm et 2,0 mm.

5. Carte de câblage à base de métal (15) selon la revendication 1, dans laquelle
les évidements (Cnm, n=1-8, m=1-8) deviennent plus petits en diamètre d'une couche à l'autre, plus les évidements (Cnm, n=1-8, m=1-8) sont proches de la base de métal (24).

6. Carte de câblage à base de métal (15) selon la revendication 1, dans laquelle
les couches isolantes (21, 22) sont réalisées dans une matière contenant de la résine et une charge inorganique.

7. Carte de câblage à base de métal (15) selon la revendication 6, dans laquelle
la charge inorganique est constituée d'une ou de plusieurs matières choisies dans un groupe constitué par la silice, l'alumine, la magnésie, l'oxyde de béryllium, le nitrure de bore, le nitrure d'aluminium, le carbure de silicium, le carbure de bore, le carbure de titane , le nitrure de silicium et le diamant.

8. Carte de câblage à base de métal (15) selon la revendication 6, dans laquelle
le motif de câblage (PA, PB) est réalisé par un procédé de transfert de motif dans chacune de la pluralité des couches isolantes (21, 22).

9. Source émettrice de lumière (10) se composant:
de la carte de câblage à base de métal (15) selon la revendication 1; et
d'éléments émetteurs de lumière (Lnm, n=1-8, m=1-8) qui ont été montés sur des faces de fond des évidements (Cnm, n=1-8, m=1-8) dans la carte de câblage à base de métal (15).

10. Source émettrice de lumière (10) selon la revendication 9, dans laquelle
chacun des éléments émetteurs de lumière (Lnm, n=1-8, m=1-8) présente une paire d'électrodes dans sa surface arrière et est monté sur une face de fond d'un évidement (Cnm, n=1-8, m=1-8) de sorte que les électrodes sont connectées au premier motif de câblage (PB).

11. Source émettrice de lumière (10) selon la revendication 10, dans laquelle
chacun des éléments émetteurs de lumière (Lnm, n=1-8, m=1-8) est un composant d'embase (60) qui comprend:
un substrat (62) ayant une borne; et
une puce nue de diode électroluminescente et/ou une diode électroluminescente (L1a) montée chacune dans une surface avant du substrat (62) et présentant une électrode dans une surface arrière de celui-ci, qui est connectée à la borne du substrat (62).

12. Source émettrice de lumière (10) selon la revendication 9, dans laquelle
chacun des éléments émetteurs de lumière (Lnm, n=1-8, m=1-8) présente une électrode aussi bien dans sa surface avant que sa surface arrière, ladite électrode dans la surface avant étant connectée au deuxième motif de câblage (PA) et l'électrode dans la surface arrière étant connectée au premier motif de câblage (PB).

13. Source émettrice de lumière (10) selon la revendication 12, dans laquelle
chacun des éléments émetteurs de lumière (Lnm, n=1-8, m=1-8) est un composant d'embase (60) qui comprend:
un substrat (62) ayant une borne, et
une puce nue de diode électroluminescente et/ou une diode électroluminescente (L1a) montée chacune dans une surface avant du substrat (62) et présentant deux électrodes qui sont connectées à des bornes respectives formées sur les surfaces avant et arrière du substrat (62).

14. Source émettrice de lumière (10) selon la revendication 9, dans laquelle
chacun des éléments émetteurs de lumière (Lnm, n=1-8, m=1-8) présente une paire d'électrodes dans sa surface avant, lesdites électrodes étant connectées par câblage par fil au motif de câblage (PA, PB).

15. Source émettrice de lumière (10) selon la revendication 14, dans laquelle
chacun des éléments émetteurs de lumière (Lnm, n=1-8, m=1-8) est un composant d'embase (60) qui comprend:
un substrat (62) ayant une borne, et
une puce nue de diode électroluminescente et/ou une diode électroluminescente (L1a) montée chacune dans une surface avant du substrat (62) et présentant une paire d'électrodes dans une surface avant de celui-ci, qui est connectée à la borne du substrat (62).

16. Dispositif d'éclairage (600) qui utilise la source émettrice de lumière (10) selon la revendication 9.

17. Dispositif d'affichage qui utilise la source émettrice de lumière (10) selon la revendication 9.
